# EUROPÄISCHE PATENTSCHRIFT

(11) **EP 3 525 346 B1**
(45) Veröffentlichungstag und Bekanntmachung des Hinweises auf die Patenterteilung: **02.04.2025**
(21) Anmeldenummer: 19160097.2
(22) Anmeldetag: 29.04.2014
(51) Int. Cl.: H03G 3/30, H04B 1/04, H03F 1/02, H03F 3/24

(54) **KOMPENSATION EINER SIGNAL-DÄMPFUNG BEI DER ÜBERTRAGUNG VON SENDESIGNALEN EINES MOBILFUNKGERÄTS**
COMPENSATION OF A SIGNAL DAMPING IN THE TRANSMISSION SIGNALS OF A MOBILE DEVICE
COMPENSATION D'UNE ATTÉNUATION DE SIGNAL LORS DE LA TRANSMISSION DES SIGNAUX D'ÉMISSION D'UN APPAREIL RADIO MOBILE

(30) Priorität: 30.04.2013 DE 102013207898
(43) Veröffentlichungstag der Anmeldung: 14.08.2019
(62) Teilanmeldung aus: 14720959.7
(73) Patentinhaber: Molex Technologies GmbH, 12529 Schönefeld (DE)
(72) Erfinder: NAST, Helmut, 12557 Berlin (DE); JACOBI, Raimo, 10318 Berlin (DE)
(74) Vertreter: Kaufmann, Tobias

(56) Entgegenhaltungen:
- US-A- 5 196 808
- US-A- 5 977 831
- US-A1- 2011 217 943
- US-B2- 7 221 967
- US-B2- 7 783 318

## Beschreibung

Die Erfindung betrifft eine Schaltungsanordnung und ein Verfahren zum Kompensieren einer Signal-Dämpfung bei der Übertragung von Sendesignalen eines Mobilfunkgeräts. Optional betrifft die Erfindung auch die Kompensation einer Signal-Dämpfung bei der Übertragung von Empfangssignalen des Mobilfunkgeräts.

Z.B. aus WO 2007/118694 A1 ist es bekannt, ein Mobiltelefon drahtlos über eine Antennenstruktur an Einrichtungen eines Kraftfahrzeugs anzukoppeln, insbesondere an eine Außenantenne des Kraftfahrzeugs. Die Sende- und Empfangssignale des Mobilfunkgeräts werden über die Außenantenne gesendet bzw. empfangen. Dadurch kann die Qualität der Funkverbindung deutlich erhöht werden.

Die Erfindung betrifft insbesondere eine Schaltungsanordnung zum Übertragen von Sende- und Empfangssignalen eines Mobilfunkgeräts (z.B. eines Mobiltelefons, eines Smart-Phones oder eines Notfallsenders), die in Kraftfahrzeugen verwendet wird. Eine Schaltungsanordnung, die insbesondere eine drahtlose Signal-Kopplungseinrichtung wie in WO 2007/118694 A1 grundsätzlich beschrieben aufweist, kann jedoch auch stationär, z.B. in Gebäuden, eingesetzt werden, um z.B. über eine Außenantenne an dem Gebäude Signale in einem Mobilfunknetz oder über eine Mobilfunkstrecke zu übertragen und so gegenüber der ausschließlichen Verwendung der Antenne des Mobilfunkgeräts die Übertragungsqualität zu verbessern.

Weiterer bekannter Stand der Technik ist z.B. US 7 221 967.

Eine Schaltungsanordnung mit der bereits erwähnten drahtlosen Signal-Kopplungseinrichtung ist der Hauptanwendungsfall der Erfindung. Eine solche Kopplungseinrichtung erleichtert die Handhabung von Mobilfunkgeräten, da keine Leitungsverbindung (d.h. insbesondere eine Kabelverbindung) zu dem Mobilfunkgerät hergestellt werden muss, um es in Kombination mit der Schaltungsanordnung betreiben zu können. Jedoch auch bei anderen Schaltungsanordnungen zur Übertragung von Sendesignalen von Mobilfunkgeräten, die zusätzlich zu dem Mobilfunkgerät eingesetzt werden, kann es durch die Schaltungsanordnung oder optional damit verbundene zusätzliche Bauteile zu einer zusätzlichen Signal-Dämpfung kommen, die durch die Schaltungsanordnung und optional durch die zusätzlichen Bauteile bewirkt wird. Insbesondere können Hochfrequenzleitungen zur Übertragung der Signale innerhalb der Schaltungsanordnung, Frequenzfilter, Frequenzweichen, Detektoren einen Beitrag zu der zusätzlichen Signaldämpfung bewirken.

Solange die zusätzliche Signaldämpfung zeitlich konstant ist, kann sie auf einfache Weise dadurch kompensiert werden, dass ein Signalverstärker mit entsprechendem, konstantem Verstärkungsfaktor die Signale wieder verstärkt und so die Dämpfung kompensiert. Dabei ist es im Gegensatz zu so genannten Repeatern, auch Umsetzer genannt, nicht erwünscht, den Signalpegel über das Niveau anzuheben, das der Signalpegel unmittelbar an der Sendeantenne des Mobilfunkgeräts (bezüglich der Sendesignale des Geräts) bzw. unmittelbar an der Außenantenne (bezüglich der aus dem Mobilfunknetz empfangenen Signale) hat. Dies wäre nachteilig, da in die Abstimmung der Sende- und Empfangsleistung eingegriffen würde, die zwischen dem Mobilfunkgerät und einer Mobilfunkstation des Mobilfunknetzes oder der Mobilfunkstrecke stattfindet. Entweder würde die Abstimmung erschwert oder beeinträchtigt oder es müsste von der Schaltungsanordnung selbst eine Abstimmung dieser Leistungen bzw. Signalpegel durch Kommunikation mit dem Mobilfunkgerät und der Mobilfunkstation ausgeführt werden. Dies wäre mit hohem schaltungstechnischem Aufwand verbunden.

Bei der oben erwähnten Art von Schaltungsanordnungen, die in Kombination mit dem jeweiligen Mobilfunkgerät eine je nach Zustand der Kombination unterschiedliche zusätzliche Signal-Dämpfung bewirken, ist das Ziel der möglichst exakten Kompensation der zusätzlichen Signal-Dämpfung nicht mit einer für jeden möglichen Zustand gleichen, konstanten Signalverstärkung erreichbar. Denkbar ist es, die zusätzliche Signal-Dämpfung in jedem der möglichen Zustände der Kombination zu ermitteln und die Signalverstärkung entsprechend einzustellen. Da aber Mobilfunkgeräte wie erwähnt ihre Sendesignale bei variabler Sendeleistung senden, je nach Ergebnis der Abstimmung mit der Mobilfunkstation, ist die Ermittlung der zusätzlichen Signal-Dämpfung nicht möglich oder erfordert wiederum eine Abstimmung mit dem Mobilfunkgerät. Z.B. müsste das Mobilfunkgerät in einem Zeitraum, der der Schaltungsanordnung bekannt ist, ein Sendesignal mit vorgegebener oder bekannter Sendeleistung senden. Problematisch dabei ist auch, dass sich der Zustand der Kopplung zwischen dem Mobilfunkgerät und der Schaltungsanordnung unvorhergesehen und in unbekannter Weise ändern kann, was zu einer Veränderung der zusätzlichen Signal-Dämpfung führt.

Z.B. kann das Mobilfunkgerät wie in WO 2007/118694 A1 oder in WO 2012/010560 A1 beschrieben, in unterschiedlichen Positionen und Ausrichtungen auf eine Auflagefläche aufgelegt werden, um die Sende- und Empfangsantenne des Mobilfunkgeräts in die Nähe einer Antennenstruktur der Schaltungsanordnung zu bringen, wobei die Antennenstruktur zumindest einen Teil einer drahtlosen Signal-Kopplungseinrichtung bildet. Während des Betriebes des Mobilfunkgeräts werden die Sende- und Empfangssignale (Hochfrequenzsignale für den Betrieb im Mobilfunknetz) zwischen der Sende- und Empfangsantenne des Mobilfunkgeräts und der Antennenstruktur drahtlos übertragen. Wegen der unterschiedlichen Positionen und Ausrichtungen ist die durch die drahtlose Kopplung bewirkte Signal-Dämpfung unterschiedlich, sodass auch die zusätzliche Signal-Dämpfung insgesamt variiert.

Es ist eine Aufgabe der vorliegenden Erfindung, eine Schaltungsanordnung und ein Verfahren zum Kompensieren einer Signal-Dämpfung bei der Übertragung von Sendesignalen eines Mobilfunkgeräts anzugeben, die bei variabler Signal-Dämpfung, die durch die Kombination des Mobilfunkgeräts mit der Schaltungsanordnung bewirkt wird, eine Kompensation der zusätzlichen Signal-Dämpfung zu bewirken, sodass beim Betrieb des Mobilfunkgeräts eine zwischen dem Mobilfunkgerät und einer entfernten Mobilfunkstation ausgehandelte Einstellung der Signalpegel nicht beeinträchtigt wird.

Es ist eine Erkenntnis der vorliegenden Erfindung, dass sich die Schaltungsanordnung in Kombination mit dem Mobilfunkgerät so wie auch bei anderen Einflussfaktoren bei der Übertragung von Funksignalen in Mobilfunksystemen verhält. Andererseits soll der Einfluss der Schaltungsanordnung aber nicht wie bei manchen anderen Einflussfaktoren (z.B. Hindernissen für die Ausbreitung von Funkwellen) zu einer Störung der Signalübertragung bis zu einem Abbruch der Funkverbindung führen.

Es soll daher eine Signalverstärkung als zumindest teilweise Kompensation der zusätzlichen Signal-Dämpfung stattfinden, die jedoch die zusätzliche Signaldämpfung im Allgemeinen nicht zu null kompensiert, auch wenn dieser Fall vorkommen kann.

Ein wesentlicher Grundgedanke der Erfindung besteht darin, die resultierende Signalverstärkung der Sendesignale in einem definierten, insbesondere vorgegebenen Bereich von Signalpegeln unverändert zu lassen und erst dann zu verändern, wenn Grenzwerte des Bereichs erreicht oder überschritten bzw. unterschritten werden. Durch diese Anpassung wird einerseits erreicht, dass die Abstimmung der Signalpegel zwischen dem Mobilfunkgerät und der Mobilfunkstation nicht beeinträchtigt wird und andererseits Maximalwerte für zulässige Signalpegel nicht oder nicht wesentlich (insbesondere im Rahmen der zulässigen Toleranzen nicht) überschritten werden. Außerdem wird erreicht, dass eine Reduktion der Sendeleistung des Mobilfunkgeräts in jedem Fall zu einer Reduktion des Signalpegels bis zum zulässigen Minimalwert des Signalpegels führt, d.h. die Mobilfunkstation und das Mobilfunkgerät auch nahe dem zulässigen Minimalwert die Sendepegel miteinander aushandeln können.

Im Folgenden wird eine konkrete Ausgestaltung beschrieben, bei der die gegebenenfalls erforderliche Anpassung der resultierenden Signalverstärkung durch Einstellung der Signal-Dämpfung einer Dämpfungseinrichtung bewirkt wird. Die oben erwähnten Grundprinzipien lassen sich jedoch auch in anderer Weise realisieren. Insbesondere kann alternativ oder zusätzlich zu der Einstellung der Signal-Dämpfung unmittelbar die Signalverstärkung zumindest eines Signalverstärkers eingestellt werden.

Bei Verwendung einer Dämpfungseinrichtung kann die Signalverstärkung eines Signalverstärkers der Schaltungsanordnung zumindest über einen vorgegebenen Zeitraum des Betriebes des Mobilfunkgeräts oder während des gesamten Betriebszeitraums auf einen konstanten Wert eingestellt sein. Dies hat den Vorteil, dass der Signalverstärker auf einfache Weise und kostengünstig hergestellt werden kann. Die resultierende Signalverstärkung ergibt sich dann aus der konstanten Signalverstärkung des Signalverstärkers abzüglich der Signal-Dämpfung einer einstellbaren Dämpfungseinrichtung. Diese Dämpfungseinrichtung kann innerhalb eines Bereichs von Signal-Dämpfungswerten kontinuierlich einstellbar sein. Bevorzugt wird allerdings eine Dämpfungseinrichtung mit diskreten, vorgegebenen Dämpfungswerten, die einstellbar sind. Z.B. kann durch das Ansteuern von Schaltern ein Dämpfungsglied hinzu- oder abgeschaltet werden. In jedem Fall erleichtert eine Dämpfungseinrichtung mit diskreten, vorgegebenen Dämpfungswerten eine digitale, insbesondere durch Mikrocontroller realisierte Steuerung, d.h. Einstellung der Signaldämpfung. Grundsätzlich ist es aber auch möglich, sowohl die Dämpfung einer Dämpfungseinrichtung als auch die Verstärkung eines Signalverstärkers einzustellen, um die resultierende Signalverstärkung einzustellen.

Unabhängig von der Realisierung der einstellbaren resultierenden Verstärkung wird bei Erreichen oder Überschreiten eines oberen Grenzwertes für den Signalpegel der Mobilfunksignale die resultierende Signalverstärkung verkleinert. Dadurch kann ein Maximalwert für die am Signalausgang der Schaltungsanordnung vorhandenen Hochfrequenzsignale eingehalten werden.

Eine weitere wesentliche Erkenntnis der Erfindung beruht jedoch darauf, dass auch bei Erreichen oder Unterschreiten eines unteren Grenzwertes des Signalpegels die resultierende Signalverstärkung verkleinert wird. Der Grund hierfür liegt darin, dass (wie oben erwähnt) in einem Signalpegel-Bereich, der im Wesentlichen (mit Ausnahme gegebenenfalls einer Hysterese im Bereich des oberen und des unteren Grenzwertes) zwischen dem unteren und dem oberen Grenzwert des Signalpegels liegt, keine Veränderung der resultierenden Signalverstärkung ausgeführt wird. Daher kann innerhalb dieses Bereichs ein Mobilfunkbetrieb stattfinden, der aus Sicht des Mobilfunkgeräts und der Mobilfunkstation keine Unterschiede zum Betrieb des Mobilfunkgeräts ohne die Schaltungsanordnung aufweist. Da die momentane zusätzliche Signaldämpfung aber nicht bekannt ist, kann die eingestellte resultierende Signalverstärkung in dem genannten Signalpegelbereich zwischen dem unteren Grenzwert und dem oberen Grenzwert zu groß sein. Versucht das Mobilfunkgerät in einer solchen Betriebssituation den Signalpegel weiter zu reduzieren (z.B. weil Signale mit zu hoher Leistung beim Empfänger der Mobilfunkstation ankommen), dann kann ein Minimalwert des Mobilfunkgeräts oder der Mobilfunkstation für den Sende-Signalpegel bzw. die Sendeleistung schon erreicht worden sein. Ohne die Schaltungsanordnung wäre dies auch nicht erforderlich. Da die resultierende Signalverstärkung der Schaltungsanordnung aber in dem angenommenen Betriebszustand zu groß ist, fordert die Mobilfunkstation z.B. von dem Mobilgerät, den Signalpegel weiter zu reduzieren, obwohl dies von dem Mobilfunkgerät aus gesehen nicht mehr zulässig und möglich ist. Daher wird gemäß der Erfindung bei Erreichen oder Unterschreiten des unteren Grenzwertes für den Signalpegel die resultierende Signalverstärkung verkleinert. In der bevorzugten Ausführungsform wird dies dadurch erreicht, dass die Signal-Dämpfung der einstellbaren Dämpfungseinrichtung auf einen größeren Wert als zuvor eingestellt wird.

Insbesondere wenn der obere Grenzwert und der untere Grenzwert des Signalpegels entsprechend eingestellt worden sind, kann in allen Betriebssituationen die Ausgangsleistung der Schaltungsanordnung im gesamten Bereich zwischen ihrem Maximalwert und ihrem Minimalwert eingestellt werden. Die für den Betrieb des Mobilfunkgeräts geforderte Dynamik wird daher eingehalten.

Insbesondere wird Folgendes vorgeschlagen: Eine Schaltungsanordnung zum Kompensieren einer Signal-Dämpfung bei der Übertragung von Sendesignalen eines Mobilfunkgeräts, wobei die Schaltungsanordnung für den Betrieb mit Mobilfunkgeräten konfiguriert ist, deren Sendeleistung durch einen jeweiligen Mobilfunkstandard durch einen Minimalwert und einen Maximalwert begrenzt ist, wobei die Schaltungsanordnung aufweist:
eine einstellbare Signalpegel-Verstärkungseinrichtung, die zumindest einen Signalverstärker zum Verstärken der Sendesignale mit einer von dem Signalverstärker erzeugten Signal-Verstärkung aufweist, eine Einstelleinrichtung zur Einstellung einer von der Signalpegel-Verstärkungseinrichtung erzeugten resultierenden Signalverstärkung, eine Detektoranordnung, die ausgestaltet ist zu detektieren, ob ein detektierter Signalpegel der an der Detektoranordnung detektierten Sendesignale eines Mobilfunkgeräts einen vorgegebenen oberen Grenzwert erreicht oder
überschreitet und ob der detektierte Signalpegel einen vorgegebenen unteren Grenzwert erreicht oder unterschreitet,
wobei
a)die Detektoranordnung und die Einstelleinrichtung miteinander verbunden sind,
b)die Detektoranordnung ausgestaltet ist, bei Erreichen oder Überschreiten des oberen Grenzwertes die Einstelleinrichtung zu veranlassen, die von der Signalpegel-Verstärkungseinrichtung erzeugte resultierende Signalverstärkung zu verkleinern, und
c) die Detektoranordnung ausgestaltet ist, bei Erreichen oder Unterschreiten des unteren Grenzwertes von oben die Einstelleinrichtung zu veranlassen, die von der Signalpegel-Verstärkungseinrichtung erzeugte resultierende Signalverstärkung zu verkleinern, und
d)die Detektoreinrichtung ferner ausgestaltet ist, bei Erreichen des unteren Grenzwertes von unten, die Einstelleinrichtung zu veranlassen, die von der Signalpegel-Verstärkungseinrichtung erzeugte resultierende Signalverstärkung derart zu erhöhen, die von der Signalpegel-Verstärkungseinrichtung erzeugte resultierende Signalverstärkung eine Kennlinie hat, die so verläuft, dass für ein mit der maximalen Sendeleistung sendendes Mobilfunkgerät der detektierte Signalpegel nicht unterhalb des oberen Grenzwertes erreicht wird.

Ferner wird vorgeschlagen: Ein Verfahren zum Kompensieren einer Signal-Dämpfung bei der Übertragung von Sendesignalen eines Mobilfunkgeräts, wobei die Sendeleistung des Mobilfunkgeräts durch einen jeweiligen Mobilfunkstandard durch einen Minimalwert und einen Maximalwert begrenzt ist, wobei:
die Signale mit einer von einem Signalverstärker erzeugten Signal-Verstärkung verstärkt werden,
die von einer einstellbaren Signalpegel-Verstärkungseinrichtung, die zumindest den Signalverstärker aufweist, erzeugte resultierende Signalverstärkung abhängig von einem Signalpegel der Sendesignale des Mobilfunkgeräts eingestellt wird, detektiert wird, ob ein detektierter Signalpegel einen vorgegebenen oberen Grenzwert erreicht oder überschreitet und ob der detektierte Signalpegel einen vorgegebenen unteren Grenzwert erreicht oder unterschreitet,
wobei
a) bei Erreichen oder Überschreiten des oberen Grenzwertes die von der Signalpegel-Verstärkungseinrichtung erzeugte resultierende Signalverstärkung verkleinert wird,
b) bei Erreichen oder Unterschreiten des unteren Grenzwertes von oben die von der Signalpegel-Verstärkungseinrichtung erzeugte resultierende Signalverstärkung verkleinert wird, und
c) bei Erreichen des unteren Grenzwertes von unten, die von der Signalpegel-Verstärkungseinrichtung erzeugte resultierende Signalverstärkung derart erhöht wird, die von der Signalpegel-Verstärkungseinrichtung erzeugte resultierende Signalverstärkung eine Kennlinie hat, die so verläuft, dass für ein mit maximaler Sendeleistung sendendes Mobilfunkgerät der detektierte Signalpegel nicht unterhalb des oberen Grenzwertes erreicht wird.

Die Signalpegel-Verstärkungseinrichtung weist bevorzugt eine Dämpfungseinrichtung auf. Die resultierende Signalverstärkung ergibt sich dann aus der Signal-Verstärkung des Signalverstärkers abzüglich der Dämpfung der Dämpfungseinrichtung. Insbesondere wird die resultierende Signalverstärkung in diesem Fall vergrößert, indem die von der Dämpfungseinrichtung erzeugte Signal-Dämpfung verkleinert wird.

Das Erreichen oder Überschreiten des oberen Grenzwertes für den Signalpegel bzw. das Erreichen oder Unterschreiten des unteren Grenzwertes des Signalpegels kann an verschiedenen Stellen bezüglich des Signalpfades innerhalb der Schaltungsanordnung detektiert werden. Bevorzugt wird, dass die Detektion von Sendesignalen des Mobilfunkgeräts im Signalpfad zwischen der einstellbaren Dämpfungseinrichtung und dem in Signallaufrichtung nachgeschalteten Signalverstärker stattfindet. In jedem Fall wird es bevorzugt, dass der Signalpegel bei der Detektion von Sendesignalen des Mobilfunkgeräts in Signallaufrichtung vor dem Signalverstärker detektiert wird.

Wenn über dieselbe Schaltungsanordnung und insbesondere über zumindest Abschnitte derselben Hochfrequenzleitung der Schaltungsanordnung sowohl Sende- als auch Empfangssignale des Mobilfunkgeräts übertragen werden und jeweils eine Kompensation der zusätzlichen Signaldämpfung stattfinden soll, wird es bevorzugt, den Signalpegel lediglich für Sendesignale des Mobilfunkgeräts zu detektieren. In diesem Fall kann angenommen werden, dass die zusätzliche Signaldämpfung für die Sendesignale und die Empfangssignale gleich ist. Daher kann auf Basis des detektierten Signalpegels bzw. der Feststellung, dass der obere Grenzwert erreicht oder überschritten ist oder der untere Grenzwert erreicht oder unterschritten ist, die resultierende Signalverstärkung eingestellt werden, und zwar in gleicher Weise für die Sendesignale und die Empfangssignale. Insbesondere kann sowohl die Übertragung der Sendesignale als auch der Empfangssignale über denselben Signalpfad der Dämpfungseinrichtung stattfinden.

Vorzugsweise ist die Schaltungsanordnung ausgestaltet, die resultierende Signalverstärkung der Signalpegel-Verstärkungseinrichtung zu vergrößern, wenn der Signalpegel den oberen Grenzwert wieder unterschritten hat. Insbesondere ist die Schaltungsanordnung ausgestaltet, die resultierende Signalverstärkung im Bereich des oberen Grenzwertes entsprechend einer Hysterese zu vergrößern und zu verkleinern. Somit zeigt die resultierende Signalverstärkung in Abhängigkeit des Signalpegels das Verhalten einer Hysterese, d.h. hängt auch von ihrem vorherigen Zustand ab. Dadurch wird erreicht, dass die resultierende Signalverstärkung in einem Bereich des Signalpegels um den oberen Grenzwert zeitlich stabil bleiben kann, d.h. nicht durch eine Verkleinerung der resultierenden Signalverstärkung den oberen Grenzwert unterschreitet und daher sofort wieder vergrößert wird usw. Bevorzugt wird daher eine Ausgestaltung der Schaltungsanordnung, bei der der obere Grenzwert ein erster oberer Grenzwert ist und die Schaltungsanordnung ausgestaltet ist, die von der Signalpegel-Verstärkungseinrichtung erzeugte resultierende Signalverstärkung zu vergrößern, wenn die Detektoranordnung detektiert, dass der Signalpegel der Sendesignale des Mobilfunkgeräts einen zweiten vorgegebenen oberen Grenzwert, der unterhalb des ersten oberen Grenzwertes liegt aber oberhalb des unteren Grenzwertes (oder bei mehreren unteren Grenzwerten oberhalb sämtlicher unterer Grenzwerte) liegt, erreicht oder unterschreitet.

Insbesondere wird die resultierende Signalverstärkung (z. B. schrittweise oder stetig) auf ihren größten einstellbaren Wert eingestellt, vorzugsweise indem die Signal-Dämpfung der Dämpfungseinrichtung auf Ihren kleinsten einstellbaren Wert eingestellt wird, bevor der Signalpegel erstmals oder erstmals wieder den unteren Grenzwert erreicht, nachdem die resultierende Signalverstärkung nach Erreichen oder Überschreiten des oberen Grenzwertes verkleinert wurde.

Der größte einstellbare Wert der resultierenden Signalverstärkung ist derjenige größte Wert, auf den die Einstelleinrichtung die Signalpegel-Verstärkungseinrichtung während des Betriebes des Mobilfunkgeräts einstellen kann. Der kleinste einstellbare Wert der Signal-Dämpfung ist derjenige kleinste Wert, auf den die Einstelleinrichtung die Dämpfungseinrichtung während des Betriebes des Mobilfunkgeräts einstellen kann. Es ist daher nicht ausgeschlossen, dass die Signalpegel-Verstärkungseinrichtung vor dem Betrieb des Mobilfunkgeräts auf einen Basis-Wert der resultierenden Signalverstärkung eingestellt wird, der kleiner ist als ein anderer möglicher Einstellwert der resultierenden Signalverstärkung der Signalpegel-Verstärkungseinrichtung. Der Basis-Wert wird zum Beispiel eingestellt, damit aus einer zeitlich konstanten Verstärkung des Signalverstärkers und dem Basis-Wert der Dämpfungseinrichtung eine Basis-Verstärkung resultiert, die auf eine erwartete Betriebssituation des Mobilfunkgeräts angepasst ist. Der Basis-Wert wird jedoch während des Betriebes des Mobilfunkgeräts nicht verändert und stellt somit den größten einstellbaren Wert der resultierenden Signalverstärkung bzw. den kleinsten einstellbaren Wert der Signal-Dämpfung dar.

Vorzugsweise ist die Schaltungsanordnung ausgestaltet, die von der Signalpegel-Verstärkungseinrichtung erzeugte resultierende Signalverstärkung zu vergrößern, wenn der Signalpegel den unteren Grenzwert wieder überschritten hat. Insbesondere ist die Schaltungsanordnung ausgestaltet, die resultierende Signalverstärkung im Bereich des unteren Grenzwertes entsprechend einer Hysterese zu vergrößern und zu verkleinern. Somit zeigt die resultierende Signalverstärkung in Abhängigkeit des Signalpegels das Verhalten einer Hysterese, d.h. hängt auch von ihrem vorherigen Zustand ab. Dadurch wird erreicht, dass die resultierende Signalverstärkung in einem Bereich des Signalpegels um den unteren Grenzwert zeitlich stabil bleiben kann, d.h. nicht durch eine Verkleinerung der resultierenden Signalverstärkung den unteren Grenzwert unterschreitet und daher sofort wieder vergrößert wird usw. Bevorzugt wird daher eine Ausgestaltung der Schaltungsanordnung, bei der der untere Grenzwert ein erster unterer Grenzwert ist und die Schaltungsanordnung ausgestaltet ist, die von der Signalpegel-Verstärkungseinrichtung erzeugte resultierende Signalverstärkung zu vergrößern, wenn die Detektoranordnung detektiert, dass der Signalpegel der Sendesignale des Mobilfunkgeräts einen zweiten vorgegebenen unteren Grenzwert, der oberhalb des ersten unteren Grenzwertes liegt aber unterhalb des oberen Grenzwertes (oder bei mehreren oberen Grenzwerten unterhalb sämtlicher oberer Grenzwerte) liegt, erreicht oder überschreitet.

Insbesondere wird die resultierende Signalverstärkung (z. B. schrittweise oder stetig) auf ihren größten einstellbaren Wert eingestellt, vorzugsweise indem die Signal-Dämpfung der Dämpfungseinrichtung auf Ihren kleinsten einstellbaren Wert eingestellt wird, bevor der Signalpegel erstmals oder erstmals wieder den oberen Grenzwert erreicht, nachdem die resultierende Signalverstärkung nach Erreichen oder Unterschreiten des unteren Grenzwertes verkleinert wurde.

Üblicherweise ist durch entsprechende Normen vorgegeben, dass der Signalpegel der von einem Mobilfunkgerät gesendeten Sendesignale beim Betrieb des Mobilfunkgeräts in einem Mobilfunknetz innerhalb eines bestimmten Signalpegel-Bereichs liegen muss, das heißt einen Minimalwert erreichen können muss und einen Maximalwert nicht überschreiten darf. Unter Verwendung dieser Informationen kann die Schaltungsanordnung konfiguriert werden.

Im Folgenden wird der Begriff einer "zusätzlichen Signal-Dämpfung" gebraucht. Darunter ist diejenige (noch nicht kompensierte) Signal-Dämpfung zu verstehen, mit der die Sendesignale des Mobilfunkgeräts durch die Übertragung der Signale mittels der Schaltungsanordnung gedämpft werden. Optional sind mit der Schaltungsanordnung weitere Bauteile verbunden, die an der Übertragung der Signale und damit auch an einer Dämpfung der Signale beteiligt sind. In diesem Fall ist die zusätzliche Signal-Dämpfung die Summe der durch die Schaltungsanordnung und die weiteren Bauteile bewirkten Signal-Dämpfung. Die Signal-Dämpfung ist "zusätzlich", weil sie bei einem Betrieb eines Mobilfunkgeräts ohne die Schaltungsanordnung und ohne die optional vorhandenen weiteren Bauteile nicht auftritt. Insbesondere beim Betrieb eines Mobilfunkgeräts innerhalb eines Kraftfahrzeugs wäre aber ohne die Schaltungsanordnung und die optional vorhandenen weiteren Bauteile (insbesondere eine Hochfrequenzleitung zu einer Außenantenne des Kraftfahrzeugs) mit einer schlechten Übertragungsqualität zu rechnen. Da es sich bei der zusätzlichen Signal-Dämpfung um eine noch nicht kompensierte Dämpfung handelt, gehören die Signalverstärkung und die optionale Signal-Dämpfung der einstellbaren Signalpegel-Verstärkungseinrichtung nicht zu den Anteilen, die die zusätzliche Signal-Dämpfung bewirken.

Um eine zusätzliche Signal-Dämpfung, wie sie zum Beispiel bei der Verwendung einer drahtlosen Signal-Kopplungseinrichtung entsteht, zu kompensieren, werden der maximale Wert der zusätzlichen Signal-Dämpfung und der minimale Wert der zusätzlichen Signal-Dämpfung ermittelt und/oder festgelegt. Im Fall der drahtlosen Signal-Kopplungseinrichtung kann zum Beispiel zumindest deren minimaler Beitrag zur zusätzlichen Signal-Dämpfung ermittelt werden. Ihr maximaler Beitrag zur zusätzlichen Signal-Dämpfung ist im Allgemeinen nicht begrenzt. Es gibt jedoch Signal-Kopplungseinrichtungen, bei deren Betrieb sich das gekoppelte Mobilfunkgerät in einem definierten räumlichen Bereich befinden muss, zum Beispiel weil es auf eine begrenzte Auflagefläche der Signal-Kopplungseinrichtung aufgelegt wird. In diesen Fällen kann auch der maximale Beitrag zur zusätzlichen Signal-Dämpfung ermittelt werden. Andernfalls kann der maximale Beitrag festgelegt werden, so dass noch ein hinsichtlich der Übertragungsqualität brauchbarer Betrieb des Mobilfunkgeräts stattfinden kann.

Im Fall der drahtlosen Signal-Kopplungseinrichtung enthält die zusätzliche Signal-Dämpfung auch Dämpfungsanteile, die auf andere Komponenten der Schaltungsanordnung und damit verbundene Teile (wie zum Beispiel eine Antenne und eine Hochfrequenzleitung für die Signale) zurückzuführen sind. In der Regel sind diese Dämpfungsanteile jedoch konstant, d.h. sie hängen insbesondere nicht von der Art des Mobilfunkgeräts und der Anordnung des Mobilfunkgeräts relativ zu der Schaltungsanordnung ab. Bei einer drahtlosen Signal-Kopplungseinrichtung hängt dagegen deren Beitrag zur zusätzlichen Signal-Dämpfung von der Art und Anordnung des Mobilfunkgeräts ab.

Der kleinste während des Betriebes des Mobilfunkgeräts einstellbare Wert der resultierenden Signalverstärkung der Signalpegel-Verstärkungseinrichtung - im Folgenden kurz: kleinster einstellbarer Wert der resultierenden Signalverstärkung wird insbesondere so festgelegt und damit vorgegeben, dass er um den Betrag der Differenz zwischen dem maximalen Wert und dem minimalen Wert der zusätzlichen Signal-Dämpfung unter dem größten einstellbaren Wert der resultierenden Signalverstärkung der Signalpegel-Verstärkungseinrichtung liegt.

Insbesondere in dem Fall, dass die resultierende Signalverstärkung durch die Signal-Dämpfung der Dämpfungseinrichtung eingestellt wird, wird der größte einstellbare Wert der Signal-Dämpfung insbesondere so festgelegt und damit vorgegeben, dass er um die Differenz zwischen dem maximalen Wert und dem minimalen Wert der zusätzlichen Signal-Dämpfung über dem kleinsten einstellbaren Wert der Signal-Dämpfung der Dämpfungseinrichtung liegt. Ferner wird die während des Betriebes des Mobilfunkgeräts und der Schaltungsanordnung zeitlich konstante Signal-Verstärkung des Signalverstärkers insbesondere so festgelegt und damit vorgegeben, dass sie dem maximalen Wert der zusätzlichen Signal-Dämpfung entspricht, das heißt die maximale zusätzliche Signal-Dämpfung zu null kompensiert.

Außerdem wird der obere Grenzwert des Signalpegels an der Detektoranordnung bzw. der obere Grenzwert für den detektierten Signalpegel so festgelegt, dass der obere Grenzwert gleich dem Signalpegel ist, der am Signal-Ausgang der Schaltungsanordnung vorhanden ist, wenn die zusätzliche Signal-Dämpfung ihren maximalen Wert hat. Insbesondere handelt es sich bei dem Signal-Ausgang der Schaltungsanordnung um den Signal-Ausgang, über den Sendesignale des Mobilfunkgeräts in ein Mobilfunknetz ausgesendet werden, zum Beispiel zu einer Basisstation des Mobilfunknetzes.

Der Mobilfunknetz-seitige Signal-Ausgang wird insbesondere durch eine Sendeantenne der Schaltungsanordnung gebildet, wobei die von der Sendeantenne in Kombination mit der Hochfrequenzleitung bewirkte Signal-Dämpfung in der zusätzlichen Signal-Dämpfung berücksichtigt ist, die zu kompensieren ist. Mit der Sendeantenne werden z. B. Sendesignale des Mobilfunkgeräts zu einer Basisstation eines Mobilfunknetzes gesendet. Üblicher Weise ist die Sendeantenne auch die Empfangsantenne, mit der Empfangssignale des Mobilfunkgeräts aus dem Mobilfunknetz empfangen werden und von dort über die Hochfrequenzleitung zu dem Mobilfunkgerät übertragen werden.

Ferner wird der untere Grenzwert des Signalpegels an der Detektoranordnung bzw. der untere Grenzwert für den detektierten Signalpegel so festgelegt, dass der untere Grenzwert gleich dem Signalpegel ist, der abzüglich des Betrages der Differenz zwischen dem maximalen Wert und dem minimalen Wert der zusätzlichen Signal-Dämpfung am Signal-Ausgang der Schaltungsanordnung vorhanden ist, wenn die zusätzliche Signal-Dämpfung ihren minimalen Wert hat. Mit anderen Worten: der untere Grenzwert des Signalpegels liegt um den Betrag der Differenz zwischen dem maximalen Wert und dem minimalen Wert der zusätzlichen Signal-Dämpfung über dem Minimalwert des zulässigen Signalpegels für den Betrieb von Mobilfunkgeräten. Im Fall von Sendesignalen gilt dieser zulässige Signalpegel wie oben erwähnt für die Antenne, über die die Sendesignale in das Mobilfunknetz ausgesendet werden. Diese Antenne ist insbesondere Teil der Schaltungsanordnung.

Wie erwähnt kann die Signalpegel-Verstärkungseinrichtung (insbesondere die Dämpfungseinrichtung) eine digitale Einrichtung sein, deren resultierende Signalverstärkung (insbesondere die Signal-Dämpfung) stufenweise durch die Einstelleinrichtung vergrößert und verkleinert werden kann. Dem entspricht eine Ausgestaltung des Verfahrens, bei dem die Signalpegel-Verstärkungseinrichtung vorgegebene, diskrete Werte der resultierende Signalverstärkung hat und die resultierende Signalverstärkung entsprechend von Differenzen der diskreten Werte stufenweise vergrößert und verkleinert wird.

Insbesondere kann die Schaltungsanordnung eine Signal-Kopplungseinrichtung aufweisen, die ausgestaltet ist, Sende-Signale einer Sendeantenne des Mobilfunkgeräts in eine Hochfrequenzleitung zur leitungsgebundenen Übertragung der Sende-Signale einzukoppeln und vorzugsweise auch Empfangs-Signale, die über die Hochfrequenzleitung zu der Signal-Kopplungseinrichtung übertragen werden, aus der Hochfrequenzleitung auszukoppeln und drahtlos zu einer Empfangsantenne des Mobilfunkgeräts zu übertragen. Erwähnt wurde bereits, dass die WO 2007/118694 A1 Ausführungsbeispiele eine solche Schaltungsanordnung beschreibt. Ein weiteres Ausführungsbeispiel für eine solche Signal-Kopplungseinrichtung ist aber z.B. ein Halter für ein Mobilfunkgerät, der das Mobilfunkgerät in einer aufrechten Position hält, wobei bei manchen dieser Halter die Position des Mobilfunkgeräts relativ zu dem Halter variieren kann. Selbst wenn die Position nicht variabel ist, können manche dieser Halter nicht nur einen Typ von Mobilfunkgeräten halten, sondern verschiedene Typen. Wenn ein solcher Halter eine drahtlose Signal-Kopplungseinrichtung aufweist, variiert in all diesen Fällen die zusätzliche Signal-Dämpfung, die zu einem wesentlichen Anteil durch die Kombination (Kopplung) des Mobilfunkgeräts über die Signal-Kopplungseinrichtung mit der Schaltungsanordnung bewirkt wird.

Die Schaltungsanordnung kann eine Sendeantenne (die z. B. eine Sende- und Empfangsantenne ist und/oder eine Außenantenne eines Kraftfahrzeugs ist) aufweisen, die über die Hochfrequenzleitung mit der Signal-Kopplungseinrichtung verbunden ist und über die beim Betrieb des Mobilfunkgeräts die Sendesignale des Mobilfunkgeräts, die von der Signal-Kopplungseinrichtung in die Hochfrequenzleitung eingekoppelt und mit der resultierenden Verstärkung verstärkt werden, gesendet werden. Zusätzlich kann die Schaltungsanordnung eine Empfangsantenne aufweisen, die über eine Hochfrequenzleitung mit der Signal-Kopplungseinrichtung verbunden ist und von der beim Betrieb des Mobilfunkgeräts Empfangssignale des Mobilfunkgeräts empfangen werden, die von der Empfangsantenne über die Hochfrequenzleitung zu der Signal-Kopplungseinrichtung übertragen und mit der resultierenden Verstärkung verstärkt von der Signal-Kopplungseinrichtung ausgekoppelt und drahtlos zu der Empfangsantenne des Mobilfunkgeräts übertragen werden. Die Empfangsantenne und die Sendeantenne sind vorzugsweise dieselbe Antenne.

Insbesondere wenn die Antenne der Schaltungsanordnung eine Sende- und Empfangsantenne ist, kann über eine einzige Hochfrequenzleitung sowohl eine Übertragung der Sendesignale als auch der Empfangssignale des Mobilfunkgeräts ausgeführt werden. Dies schließt nicht aus, dass in einzelnen Abschnitten des Signalpfades auch eine getrennte Übertragung der Sendesignale und der Empfangssignale in separaten Leitungsabschnitten stattfinden kann. Insbesondere sind sowohl der Sendeverstärker als auch ein zusätzlicher Empfangsverstärker zum Verstärken der Empfangssignale vorhanden, sodass die Leitungsabschnitte der Verstärker separate Leitungsabschnitte ausschließlich für die Sendesignale bzw. die Empfangssignale sind. Alternativ ist es selbstverständlich möglich, dass die Schaltungsanordnung einen zwischen Signaleingang und Signalausgang durchgehende Hochfrequenzleitung ausschließlich für Sendesignale aufweist und eine zwischen Signaleingang und Signalausgang durchgehende Hochfrequenzleitung ausschließlich für Empfangssignale des Mobilfunkgeräts aufweist, wobei die Signaleingänge und Signalausgänge für die Sende- und Empfangssignale verschieden sind. Bei einer gemeinsamen Hochfrequenzleitung für Sendesignale und Empfangssignale befindet sich z.B. der Signalausgang für die Sendesignale und der Signaleingang für die Empfangssignale an der Sende- und Empfangsantenne der Schaltungsanordnung, die für die unmittelbare Kommunikation in dem Mobilfunknetz bzw. über die Mobilfunkstrecke dient. Dagegen befinden sich z.B. der Signalausgang für die Empfangssignale und der Signaleingang für die Sendesignale an der drahtlosen Signal-Kopplungseinrichtung, über die die Schaltungsanordnung mit dem Mobilfunkgerät gekoppelt ist. Das Mobilfunkgerät selbst gehört selbstverständlich nicht zu der Schaltungsanordnung.

Insbesondere kann die Schaltungsanordnung ausgestaltet sein, in Kombination mit einem Mobilfunkgerät betrieben zu werden, wobei die Mobilfunksignale je nach Mobilfunkstandard in unterschiedlichen Frequenzbändern liegen können. Allgemeiner formuliert ist die Schaltungsanordnung insbesondere geeignet, bei Signalfrequenzen in unterschiedlichen Hochfrequenzbändern betrieben zu werden. Z.B. ist den verschiedenen bekannten Mobilfunkstandards jeweils zumindest ein Frequenzband zugeordnet. Eine universelle Schaltungsanordnung für den Betrieb in Mitteleuropa muss beispielsweise für Signalfrequenzen in acht verschiedenen Frequenzbändern geeignet sein.

Daher kann die Schaltungsanordnung optional parallele Signalpfade und/oder einzelne Schaltungsbauteile aufweisen, die lediglich für den Betrieb in einem der möglichen Frequenzbänder geeignet sind oder verwendet werden. Entsprechende Gestaltungen von solchen Schaltungsanordnungen sind an sich bekannt. In Bezug auf die Erfindung bedeutet dies, dass mehrere Signalverstärker und/oder einstellbare Dämpfungseinrichtungen für die verschiedenen Frequenzbänder und/oder die individuellen Signalpfade vorgesehen sein können. Bevorzugt wird jedoch zumindest für den Signalverstärker, dass er Hochfrequenzsignale nicht nur in einem Frequenzband, sondern mehreren Frequenzbändern verstärkt, d.h. beim Betrieb der Schaltungsanordnung gemäß verschiedenen Mobilfunkstandards verwendbar ist. Dies bedeutet nicht zwangsläufig, dass derselbe Signalverstärker für alle möglichen Mobilfunkstandards bzw. Frequenzbänder verwendet wird. Für die einstellbare Dämpfungseinrichtung gilt ebenfalls vorzugsweise, dass sie für die Dämpfung des Signalpegels von Signalen in verschiedenen Frequenzbändern und/oder gemäß verschiedenen Mobilfunkstandards verwendet wird.

Bei der Verwendung desselben Signalverstärkers für Signale in verschiedenen Frequenzbändern kann der Verstärkungsfaktor geringfügig von der Frequenz abhängen und daher für die verschiedenen Frequenzbänder variieren. Dies kann beispielsweise dadurch ausgeglichen werden, dass für den Betrieb in einem Frequenzband, in dem die Signalverstärkung des Signalverstärkers größer ist als in einem anderen Frequenzband, ein Dämpfungsglied der einstellbaren Dämpfungseinrichtung permanent eingeschaltet, d.h. wirksam ist. Dieses Dämpfungsglied steht dann während des Betriebes nicht für die Einstellung der Signal-Dämpfung zur Verfügung. Auch kann es zweckmäßig sein, die unterschiedlichen Vorschriften in den verschiedenen Mobilfunkstandards für den maximalen Signalpegel und den minimalen Signalpegel von Sende- und/oder Empfangssignalen dadurch einzuhalten, dass vor oder zu Beginn des Betriebes ein oder mehrere Dämpfungsglieder der einstellbaren Dämpfungseinrichtung eingeschaltet (d.h. wirksam) oder ausgeschaltet (d.h. unwirksam) werden, und zwar für die gesamte Betriebsdauer gemäß dem jeweiligen Mobilfunkstandard. Auch können einzelne Dämpfungsglieder der einstellbaren Dämpfungseinrichtung permanent während der gesamten Betriebsdauer gemäß einem bestimmten Mobilfunkstandard ausgeschaltet bleiben, sodass die Differenz zwischen der während des Betriebes größten einstellbaren Signaldämpfung und der kleinsten einstellbaren Signaldämpfung festlegbar ist. Diese Differenz kann in gleicher Weise auch dann auf einen anderen Wert festgelegt werden als zuvor, wenn ein anderes Mobilfunkgerät als zuvor in Kombination mit der Schaltungsanordnung betrieben wird.

Ausführungsbeispiele der Erfindung werden nun unter Bezugnahme auf die beigefügte Zeichnung beschrieben. Die einzelnen Figuren der Zeichnung zeigen:

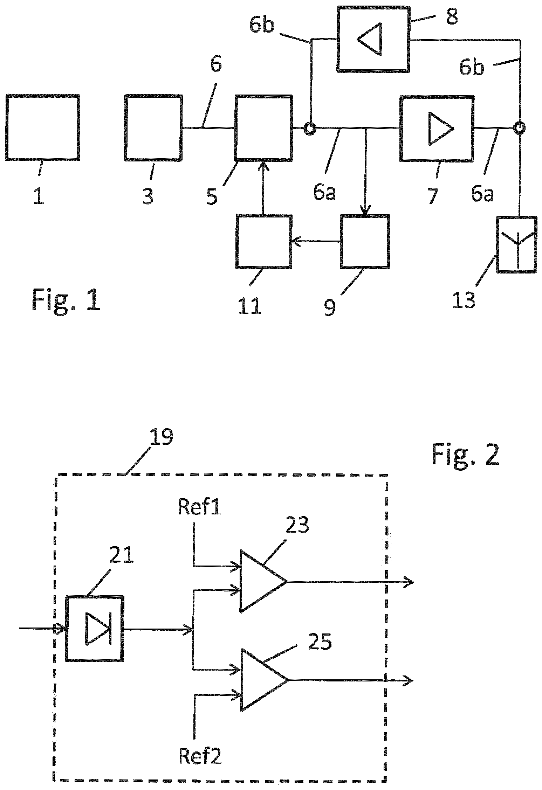

- Fig. 1: eine Schaltungsanordnung mit einer drahtlosen Signal-Kopplungseinrichtung, einer einstellbaren Dämpfungseinrichtung, einem Signalverstärker, einer Detektionseinrichtung und einer Einstelleinrichtung zur Einstellung der Dämpfungseinrichtung sowie einer Sende- und Empfangsantenne, wobei die Schaltungsanordnung mit einem Mobilfunkgerät kombiniert ist,
- Fig. 2: ein Ausführungsbeispiel für eine Detektionseinrichtung zur Detektion, ob der Signalpegel eines Hochfrequenzsignals einen oberen Grenzwert erreicht oder überschreitet und ob der Signalpegel einen unteren Grenzwert erreicht oder unterschreitet, wobei die Detektionseinrichtung insbesondere Teil der in Fig. 1 dargestellten Schaltungsanordnung sein kann,

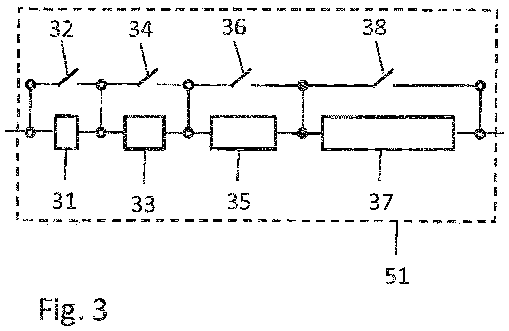

- Fig. 3: ein Ausführungsbeispiel für eine Dämpfungseinrichtung mit einer Mehrzahl von Dämpfungsgliedern, die einzeln zuschaltbar und abschaltbar sind, indem jeweils ein parallel zu dem Dämpfungsglied angeordneter Schalter ausgeschaltet oder eingeschaltet wird, wobei die Dämpfungseinrichtung insbesondere Teil der in Fig. 1 dargestellten Schaltungsanordnung sein kann,

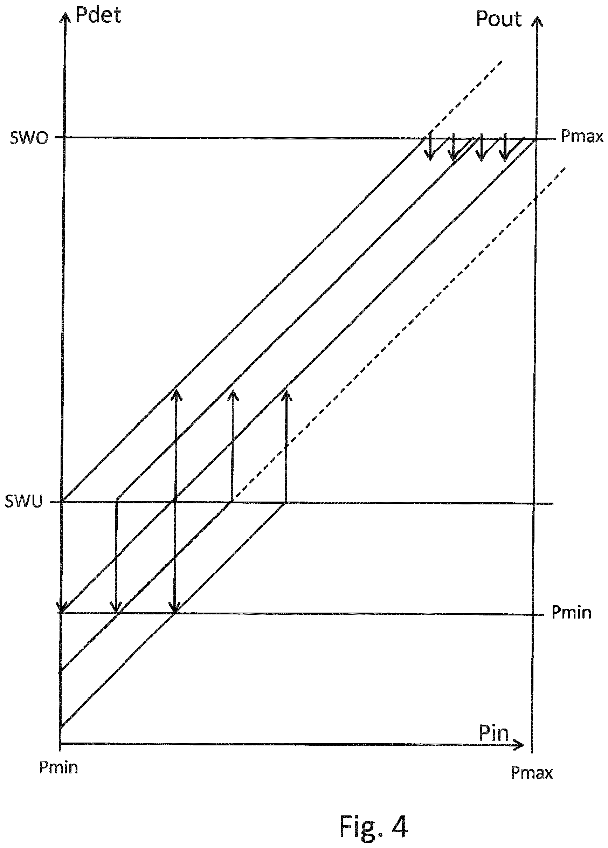

- Fig. 4: ein Diagramm, bei dem auf der Abszisse Werte der Sendeleistung eines Mobilfunkgeräts aufgetragen sind und auf der Ordinate parallel in zwei verschiedenen Skalen Werte der Ausgangsleistung am Signalausgang einer Schaltungsanordnung und Werte des Signalpegels des Mobilfunkgeräts an einer Detektionseinrichtung der Schaltungsanordnung aufgetragen sind, wobei ferner in dem Diagramm eine Kurvenschar von parallel zueinander verlaufenden Geraden mit positiver Steigung dargestellt ist, deren Schar Parameter die zusätzliche Signaldämpfung der Schaltungsanordnung in Kombination mit dem Mobilfunkgerät ist,

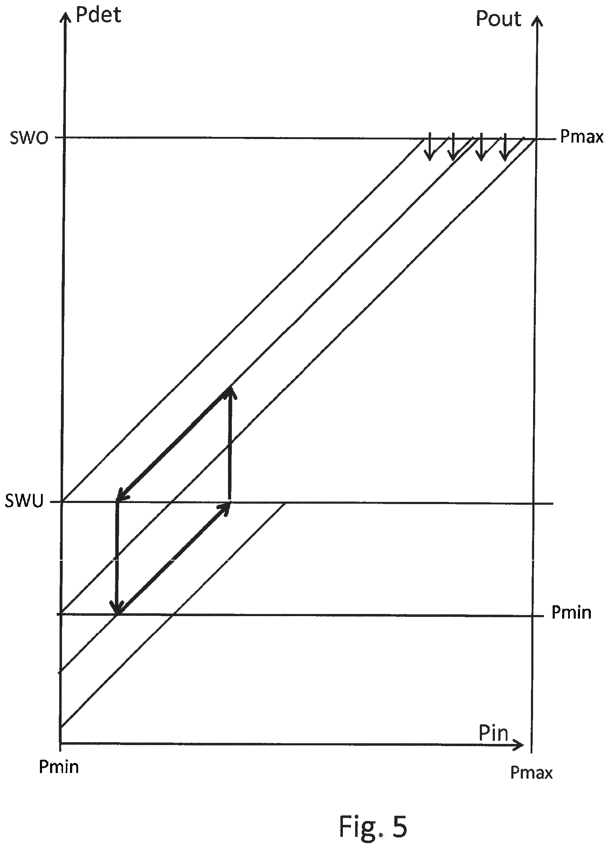

- Fig. 5: ein Diagramm ähnlich wie das Diagramm in Fig. 4 zur Darstellung der Vergrößerung und Verkleinerung der resultierenden Signalverstärkung bzw. des Signalpegels am Signalausgang der Schaltungsanordnung, bei Unterschreiten des unteren Grenzwertes des Signalpegels und anschließendem Wieder-Überschreiten des unteren Grenzwertes des Signalpegels,

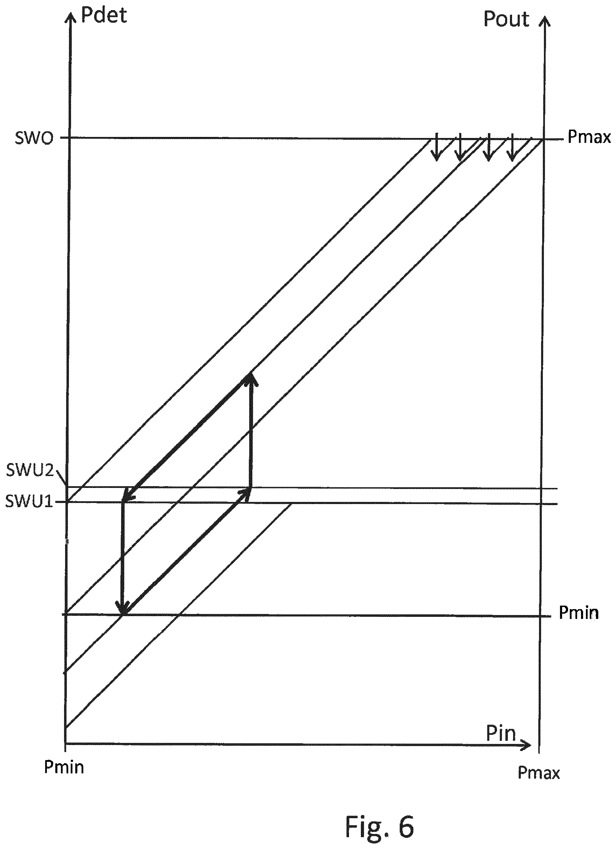

- Fig. 6: ein Diagramm ähnlich dem in Fig. 5, wobei eine Hysterese der resultierenden Signalverstärkung bzw. des Signalpegels unter Verwendung von zwei unteren Grenzwerten dargestellt ist, und

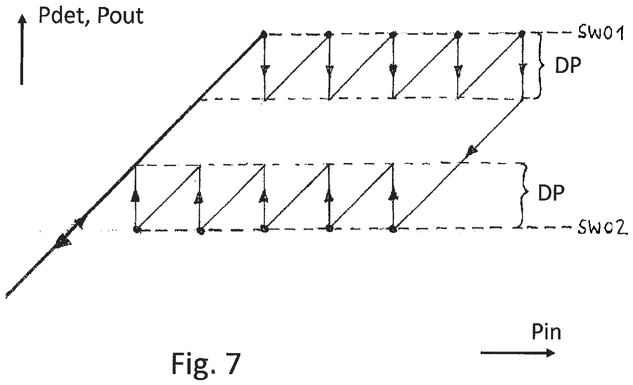

- Fig. 7: eine Realisierung einer Hysterese der resultierenden Signalverstärkung bzw. des Signalpegels unter Verwendung von zwei oberen Grenzwerten.

Die in Fig. 1 dargestellte Schaltungsanordnung weist eine drahtlose Signal-Kopplungseinrichtung 3, eine einstellbare Dämpfungseinrichtung 5, einen Sendesignalverstärker 7 und eine Antenne 13 auf, die in dieser Reihenfolge im Signalpfad für Sendesignal eines Mobilfunkgeräts 1 angeordnet sind. Abschnitte einer entsprechenden Hochfrequenzleitung der Schaltungsanordnung sind mit den Bezugszeichen 6 und 6a bezeichnet. Außerdem weist die Schaltungsanordnung einen Empfangssignalverstärker 8 auf, der über einen Abschnitt 6b der Hochfrequenzleitung, welcher zu dem Abschnitt 6a der Hochfrequenzleitung antiparallel verläuft, mit der Antenne 13 und der einstellbaren Dämpfungseinrichtung 5 verbunden ist. Ferner sind eine Detektionseinrichtung 9 und eine Einstelleinrichtung 11 vorgesehen. Die Detektionseinrichtung 9 ist in dem Ausführungsbeispiel mit dem Abschnitt 6a der Hochfrequenzleitung 6 zwischen der einstellbaren Dämpfungseinrichtung 5 und dem Sendesignalverstärker 7 verbunden. Der Signalpegel wird daher bei Sendesignalen des Mobilfunkgeräts 1 detektiert, nachdem die Signale von der Dämpfungseinrichtung 5 gedämpft wurden, aber bevor die Signale von dem Sendesignalverstärker 7 verstärkt werden.

Ein Signalausgang der Detektionseinrichtung 9 ist mit einem Signaleingang der Einstelleinrichtung 11 verbunden. Diese ist z.B. eine Steuerung zum Steuern des Schaltzustandes von Schaltern der einstellbaren Dämpfungseinrichtung 5. Auf ein entsprechendes Ausführungsbeispiel wird noch anhand von Fig. 3 eingegangen.

Die Schaltungsanordnung ist über die drahtlose Signal-Kopplungseinrichtung 3 mit einer Sende- und Empfangsantenne (nicht dargestellt) des Mobilfunkgeräts gekoppelt. Diese Kopplung kann auch als Luftschnittstelle bezeichnet werden. Allerdings können sich zwischen der Antenne des Mobilfunkgeräts 1 und der Signal-Kopplungseinrichtung 3 auch Materialien befinden, die vorzugsweise nicht elektrisch leitend sind.

Aufgrund des Abschnitts 6b mit dem Empfangssignalverstärker 8 kann die Schaltungsanordnung nicht nur für die Übertragung von Sendesignalen des Mobilfunkgeräts 1, sondern auch für die Übertragung von Empfangssignalen aus einem Mobilfunknetz oder von einer Mobilfunkstrecke genutzt werden. Die Empfangssignale werden von der Antenne 13 empfangen, dem Empfangssignalverstärker 8 zugeführt, der sie verstärkt, und dann zu dem für Sende- und Empfangssignale gemeinsamen Abschnitt 6 der Hochfrequenzleitung geleitet. Insgesamt findet eine Detektion des Signalpegels ausschließlich für die Sendesignale statt (wie oben beschrieben).

Modifikationen der in Fig. 1 dargestellten Schaltungsanordnung sind möglich. Z.B. kann die Detektionseinrichtung 9 den Signalpegel in dem Abschnitt der Hochfrequenzleitung 6a zwischen dem Sendesignalverstärker 7 und der Antenne 13 detektieren.

Die durch die Kopplung zwischen Mobilfunkgerät 1 und Kopplungseinrichtung 3 bewirkte Signaldämpfung kann wie oben erwähnt unterschiedliche Werte haben, insbesondere je nach Position und Ausrichtung des Mobilfunkgeräts 1 und je nach Art des Mobilfunkgeräts 1. Außerdem kommt zu der oben definierten "zusätzlichen Signaldämpfung" noch die durch die Schaltungsanordnung bewirkte Signaldämpfung hinzu, die aber in der Regel konstant ist und für die verschiedenen Mobilfunkgerätetypen, die Positionen und die Ausrichtungen gleich ist.

Die Detektionseinrichtung 9 ist über ihren Detektionssignalausgang mit der Einstelleinrichtung 11 verbunden. Insbesondere wenn das Erreichen oder Überschreiten des oberen Grenzwertes oder das Erreichen oder Unterschreiten des unteren Grenzwertes festgestellt wurde, wird ein entsprechendes Detektionssignal von der Detektionseinrichtung 9 zu der Einstelleinrichtung 11 ausgegeben, die die einstellbare Dämpfungseinrichtung 5 dann entsprechend einstellt. Vorzugsweise gibt die Detektionseinrichtung 9 permanent oder wiederholt, insbesondere zyklisch, ein Detektionssignal aus, das den jeweiligen Zustand des Signalpegels beschreibt. Die Detektionseinrichtung 9 gibt in besonders bevorzugter Ausgestaltung zwei solche Zustandssignale an die Einstelleinrichtung 11 aus. Das eine Zustandssignal enthält die Information, ob der obere Grenzwert erreicht oder überschritten ist (erster Zustand) oder ob der obere Grenzwert nicht erreicht ist (zweiter Zustand des ersten Zustandssignals). Entsprechend hat das zweite Zustandssignal ebenfalls zwei Zustände. Der erste Zustand bedeutet, dass der untere Grenzwert erreicht oder unterschritten ist. Der zweite Zustand bedeutet, dass dies nicht der Fall ist.

Wenn eine Hysterese des Signalpegels erreicht werden soll, kann dies insbesondere durch die Detektionseinrichtung 9 erzielt werden. Wenn z.B. der Signalpegel ansteigt und den oberen Grenzwert erreicht oder überschreitet, kann die Detektionseinrichtung 9 dies (z.B. durch das erste Zustandssignal) an die Einstelleinrichtung 11 signalisieren. Dies wird erfindungsgemäß dazu führen, dass die resultierende Verstärkung reduziert wird, insbesondere durch Erhöhung der von der Dämpfungseinrichtung 5 bewirkten Signaldämpfung. Daher wird der Signalpegel wieder reduziert. Die Detektionseinrichtung 9 kann nun so ausgestaltet sein, dass sie erst dann ein Unterschreiten des oberen Grenzwertes an die Einstelleinrichtung 11 signalisiert (beispielsweise durch Änderung des Zustands des ersten Zustandssignals), wenn ein zweiter oberer Grenzwert, der unterhalb des ersten oberen Grenzwertes liegt, erreicht oder unterschritten ist. Ein Ausführungsbeispiel wird noch anhand von Fig. 7 beschrieben. Entsprechend kann die Hysterese um den unteren Grenzwert realisiert werden.

In Fig. 2 ist eine schematische Schaltungsanordnung für eine Ausführungsform einer Detektionseinrichtung 19 dargestellt.

Insbesondere stellt die Ausgestaltung der Fig. 2 eine Realisierung dar, die oben bei der Beschreibung der Fig. 1 als mögliche Ausgestaltung der Detektionseinrichtung 9 erwähnt wurde. Der zu detektierende Signalpegel liegt an einem Gleichrichter 21 der Detektionseinrichtung 19 (links in Fig. 2) an. Der Gleichrichter 21 ist mit seinem Ausgang für das gleichgerichtete HF-Signal sowohl mit einem ersten Komparator 23 als auch mit einem zweiten Komparator 25 verbunden. Beide Komparatoren 23, 25 weisen einen weiteren Signaleingang auf, um jeweils ein Referenzsignal Ref1 bzw. Ref2 zu empfangen. Die Referenzsignale Ref1 und Ref2 entsprechen dem oberen bzw. unteren Grenzwert für den Signalpegel. Erreicht daher der Signalpegel den oberen Grenzwert oder überschreitet diesen, ändert sich das Ausgangssignal am Ausgang des ersten Komparators 23 im Vergleich zu dem Zustand, in dem der Signalpegel unterhalb des oberen Grenzwertes liegt. Insbesondere liegt daher am Ausgang des ersten Komparators 23 das oben erwähnte erste Zustandssignal an. Entsprechend liegt am Ausgang des zweiten Komparators 25 z.B. das oben erwähnte zweite Zustandssignal an. Das HystereseVerhalten kann durch geeignete Ausgestaltung der Komparatoren gegebenenfalls mit zusätzlicher Beschaltung mit weiteren Beschaltungsbauteilen (nicht dargestellt) erzielt werden.

Das in Fig. 3 dargestellte Ausführungsbeispiel einer Dämpfungseinrichtung 51, die beispielsweise als Dämpfungseinrichtung 5 in der in Fig. 1 dargestellten Schaltungsanordnung eingesetzt werden kann, weist eine Mehrzahl von in Reihe zueinander geschalteten Dämpfungsglieder 31, 33, 35, 37 auf, wobei die Anzahl und Dämpfungswirkung der Dämpfungsglieder bei verschiedenen Ausgestaltungen der Dämpfungseinrichtung variieren kann. Im Ausführungsbeispiel ist ein erstes Dämpfungsglied 31 dargestellt, das die halbe Dämpfungswirkung des nächstfolgenden Dämpfungsgliedes 33 usw. hat. Daher hat das Dämpfungsglied 31 in dem Ausführungsbeispiel 1/8 der Dämpfungswirkung des vierten Dämpfungsglieds 37. Das dritte Dämpfungsglied 35 hat die halbe Dämpfungswirkung des Dämpfungsglieds 37 und die doppelte Dämpfungswirkung des zweiten Dämpfungsglieds 33.

Parallel zu jedem der Dämpfungsglieder 31-37 ist jeweils eine Bypassleitung angeordnet, in der sich ein dem jeweiligen Dämpfungsglied 31-37 zugeordneter Schalter 32, 34, 36, 38 befindet. Im eingeschalteten Zustand des jeweiligen Schalters 32-38 ist das zugeordnete Dämpfungsglied unwirksam, da die Bypassleitung durchgeschaltet ist und daher parallel zu dem Dämpfungsglied eine Signalübertragung stattfinden kann, die ungedämpft ist.

Nicht dargestellt in Fig. 3 sind entsprechende Steueranschlüsse der steuerbaren Schalter 32, 34, 36, 38. Über diese Steueranschlüsse können die Schalter von einer entsprechenden Einstelleinrichtung, z.B. der Einstelleinrichtung 11 in Fig. 1, angesteuert und somit ein- oder ausgeschaltet werden. Es ist somit möglich, die in Fig. 3 dargestellte digitale Dämpfungseinrichtung 51 computerisiert zu steuern und beliebige Dämpfungswerte in Stufen der Dämpfungswirkung des ersten Dämpfungsglieds 31 (im Folgenden Wert "1") bis zum fünfzehnfachen, d.h. bis zum Wert "15", einzustellen. Außerdem kann der Wert "0" eingestellt werden, wenn sämtliche Schalter 32, 34, 36, 38 geschlossen sind.

Das in Fig. 4 dargestellte Diagramm zeigt auf der Abszisse die Eingangsleistung bzw. den Eingangs-Signalpegel Pin, wobei die Eingangsleistung Pin im Fall der Übertragung von Sendesignalen eines an die Schaltungsanordnung angeschlossenen Mobilfunkgeräts die Sendeleistung der Sendesignale an der Sendeantenne des Mobilfunkgeräts ist. Beim Betrieb des Mobilfunkgeräts in einem Mobilfunknetz ist diese Sendeleistung Pin gemäß den Vorschriften des jeweiligen Mobilfunkstandards durch einen Minimalwert Pmin und durch einen Maximalwert Pmax begrenzt.

In Ordinatenrichtung ist rechts die Ausgangsleistung Pout der Schaltungsanordnung aufgetragen, die an einer Sendeantenne der Schaltungsanordnung entsprechend den Vorschriften des Mobilfunkstandards zwischen dem Minimalwert Pmin und dem Maximalwert Pmax liegen muss. Links ist in Ordinatenrichtung der Signalpegel bzw. die Signalleistung Pdet an der Detektionseinrichtung aufgetragen. Da die detektierte Leistung Pdet entweder gleich der Ausgangsleistung Pout ist oder sich davon um den konstanten Betrag der Signalverstärkung des Signalverstärkers unterscheidet, können die detektierte Leistung Pdet und die Ausgangsleistung Pout parallel zueinander aufgetragen werden. An der linken Ordinatenachse sind der obere Grenzwert SWO und der untere Grenzwert SWU dargestellt. Der untere Grenzwert SWU liegt oberhalb des Minimalwertes Pmin der Ausgangsleistung Pout.

Bei der Konfiguration der Schaltungsanordnung wird die Information über die minimal mögliche Kopplungsdämpfung zwischen Schaltungsanordnung und Mobilfunkgerät und über die maximal mögliche Kopplungsdämpfung zwischen Mobilfunkgerät und Schaltungsanordnung verwendet. Im Fall der bevorzugten Ausgestaltung mit der Dämpfungseinrichtung ist die Differenz zwischen diesen Grenzwerten der Kopplungsdämpfung gleich der Differenz zwischen der größten einstellbaren Signaldämpfung der Dämpfungseinrichtung und der kleinsten einstellbaren Signaldämpfung der Dämpfungseinrichtung. Z.B. beträgt die gesamte zusätzliche Signaldämpfung der Dämpfungseinrichtung, einschließlich der Kopplungsdämpfung, 3 ... 13 dB. In diesem Fall wird der Einstellbereich für die Signaldämpfung der Dämpfungseinrichtung von 0 ... 10 dB gewählt. Ferner wird die konstante Signalverstärkung des Signalverstärkers auf den Betrag festgelegt, der dem Maximalwert der zusätzlichen Signaldämpfung entspricht, im Ausführungsbeispiel somit 13 dB. Im Fall einer einstellbaren Signalverstärkung des Sendesignalverstärkers ohne einstellbares Dämpfungsglied wird der Einstellbereich für die Signalverstärkung für den zuvor genannten Fall von 3 ... 13 dB gewählt. Für einen Betrieb gemäß dem Mobilfunkstandard GSM 900 z.B. beträgt der Minimalwert Pmin der Eingangsleistung Pin und der Ausgangsleistung Pout 5 dBm. Der Maximalwert Pmax der Eingangsleistung Pin und der Ausgangsleistung Pout beträgt 33 dBm. Bei anderen Mobilfunkstandards gelten entsprechend andere Grenzwerte. Bei dem genannten Beispiel des GSM 900 wird der obere Grenzwert SWO für den Signalpegel Pdet auf den Wert gesetzt, der dem Maximalwert Pmax der Ausgangsleistung Pout entspricht (hier: 20 dBm). Dies gilt selbstverständlich für alle anderen Mobilfunkstandards auch. Der untere Grenzwert für Pdet wird auf den Wert 2 dBm gesetzt, wenn sich der detektierte Signalpegel Pdet um die Signalverstärkung des Signalverstärkers (z.B. 13 dB) von der Ausgangsleistung Pout unterscheidet. Wenn der Signalpegel der Ausgangsleistung gemessen wird, würde der untere Grenzwert SWU auf den Wert 15 dBm gesetzt. Der Minimalwert Pmin für die Ausgangsleistung Pout liegt um den Wert (hier im Beispiel: 10 dB) unter dem unteren Grenzwert SWU, mit dem die Kopplungsdämpfung variieren kann. Dies gewährleistet, dass eine Reduzierung der Eingangsleistung Pin immer zu einer Reduzierung der Ausgangsleistung Pout führt.

In der Darstellung der Fig. 4 und auch der folgenden Fig. 5 und 6 sind die Abszisse und die Ordinaten gleich skaliert, d.h. die Abstände zwischen der Minimalleistung Pmin und der Maximalleistung Pmax sind auf beiden Achsen gleich groß. Daher verlaufen in dem Diagramm Geraden mit der Steigung 1 unter einem Winkel von 45° gegen die Abszisse und Ordinate. Es sind mehrere solche Linien eingezeichnet. In dem Ordinatenbereich zwischen dem unteren Grenzwert SWU und dem oberen Grenzwert SWO können einige dieser Kennlinien durchgehend verlaufen, ohne dass die Grenzen des Minimalwertes Pmin oder des Maximalwertes Pmax entweder auf der Abszisse oder auf der Ordinate überschritten werden. Es gibt jedoch auch einige dieser Kennlinien, die unterhalb des unteren Grenzwertes SWU verlaufen und bei Verlängerung nach oben rechts den Maximalwert Pmax für die Eingangsleistung Pin überschreiten würden, bevor der obere Grenzwert SWO erreicht ist. Für eine dieser Kennlinien ist dieses Verhalten durch eine gestrichelte Linie dargestellt. Da dieses Verhalten nicht zulässig ist, ist eine Anpassung der resultierenden Signalverstärkung, insbesondere der Signaldämpfung der Dämpfungseinrichtung, erforderlich.

Entsprechendes gilt für einige Kennlinien, die zwar zwischen dem unteren Grenzwert SWU und dem oberen Grenzwert SWO durchgehen, ohne den durch den Minimalwert Pmin und durch den Maximalwert Pmax begrenzten Bereich auf der Abszisse oder der Ordinate zu verlassen. Diese Kennlinien erreichen aber den oberen Grenzwert SWO und würden bei weiter ansteigender Eingangsleistung Pin den Grenzwert übersteigen, d.h. der Maximalwert Pmax der Ausgangsleistung Pout würde überschritten. Auch dieses Verhalten ist für eine Kennlinie durch eine gestrichelte Linie dargestellt.

Der Parameter der verschiedenen Kennlinien ist die zusätzliche Signaldämpfung, die es zu kompensieren gilt. Je weiter oben links die Kennlinie verläuft, desto kleiner ist die zusätzliche Signaldämpfung der Schaltungsanordnung einschließlich der Kopplungsdämpfung. Von den dargestellten Kennlinien entspricht die am weitesten links oben gelegene Kennlinie dem kleinsten möglichen Wert der zusätzlichen Signaldämpfung. Die am weitesten unten rechts gelegene Kennlinie entspricht dem größten Wert der zusätzlichen Signaldämpfung. Es ist eine Kennlinie eingezeichnet, entlang der der Wert der Eingangsleistung gleich dem Wert der Ausgangsleistung Pout ist, d.h. die Signaldämpfung der Dämpfungseinrichtung ist z.B. 0 und die Signalverstärkung des Signalverstärkers gleicht bei maximaler zusätzlicher Signaldämpfung diese aus oder es herrscht eine andere zusätzliche Signaldämpfung und die Dämpfungseinrichtung ist auf einen Wert mit einer größeren Signaldämpfung eingestellt. Dieses Beispiel veranschaulicht, dass sich die Kennlinien außer am Rand des Kennlinienfeldes nicht eindeutig durch die zusätzliche Signaldämpfung oder den eingestellten Wert der resultierenden Signalverstärkung kennzeichnen lassen. Diese Kenntnis ist aber auch nicht erforderlich, da in der erfindungsgemäßen Weise lediglich bei Erreichen oder Überschreiten des oberen Grenzwertes und bei Erreichen oder Unterschreiten des unteren Grenzwertes die resultierende Signalverstärkung reduziert wird. Dadurch findet ein Versatz in vertikaler Richtung (in Ordinatenrichtung) von einer Kennlinie zu einer parallelen Kennlinie statt. Ein solcher Versatz ist im Bereich des oberen Grenzwertes SWO und des unteren Grenzwertes SWU durch verschiedene Pfeile dargestellt. Im Bereich des unteren Grenzwertes SWU ist auch ein Versatz nach oben dargestellt, denn die resultierende Signalverstärkung soll möglichst nahe an dem Grenzwert auch wieder erhöht werden, damit das Mobilfunkgerät und die Mobilfunkstation die Signalpegel über einen größeren Bereich von Pegelwerten möglichst ungestört miteinander aushandeln können und damit bei Erreichen des oberen Grenzwertes SWO wieder eine Reduktion der resultierenden Verstärkung möglich ist bzw. eine Erhöhung der Signaldämpfung. Auch um den oberen Grenzwert SWO könnten Pfeile nach oben dargestellt werden, um die entsprechenden Maßnahmen zur erneuten Erhöhung der resultierenden Signalverstärkung darzustellen, wenn der Signalpegel der Eingangsleistung Pin wieder abnimmt.

An dem oberen Grenzwert SWO sind mehrere kurze Pfeile nach unten dargestellt, deren Spitzen an kurzen Abschnitten von weiteren Kennlinien enden, die sich bis zum oberen Grenzwert SWO erstrecken. Dadurch wird angedeutet, dass die resultierende Signalverstärkung in mehreren kleinen Stufen reduziert werden kann. Dies führt zu einem besonders stabilen Verhalten des Ausgangssignals mit der Ausgangsleistung Pout in Abhängigkeit der Eingangsleistung Pin.

Ein entsprechendes Verhalten kann auch an dem unteren Grenzwert SWU erzeugt werden. Die längeren Pfeile in Fig. 4 um den unteren Grenzwert SWU deuten aber an, dass auch lediglich mit einer Stufe der Änderung der resultierenden Signalverstärkung gearbeitet werden kann.

In Fig. 5 ist eine Vergrößerung und Verkleinerung der resultierenden Signalverstärkung um den unteren Grenzwert SWU herum dargestellt. Z.B. kann sich die Eingangsleistung Pin reduzieren, wobei der Zustand der Schaltungsanordnung z.B. durch die zweite dargestellte Kennlinie (von oben links gesehen) beschrieben wird. Durch die Reduzierung der Eingangsleistung Pin verändert sich der Zustand daher entsprechend dem von rechts oben nach links unten verlaufenden Pfeil, bis der untere Grenzwert SWU erreicht ist. Diese Kennlinie könnte nicht bis zum Minimalwert Pmin der Ausgangsleistung Pout verlängert werden, ohne den Minimalwert Pmin der Eingangsleistung Pin zu unterschreiten. Wenn das Mobilfunkgerät daher seine Sendeleistung so verringert, dass entlang dieser Kennlinie die Eingangsleistung auf Pmin reduziert wird, wird das Minimum Pmin der Ausgangsleistung Pout erreicht und eine weitere Reduktion der Sendeleistung des Mobilfunkgeräts könnte nicht zu einer noch geringeren Ausgangsleistung Pout führen. Dies ist aber für den Betrieb von Mobilfunkgeräten nicht zulässig. Daher wird die resultierende Signalverstärkung bereits bei Erreichen des unteren Grenzwertes SWU verringert, und zwar z. B. um einen einzigen Schritt, sodass die Ausgangsleistung Pout auf ihren Minimalwert Pmin reduziert wird. Wenn die Eingangsleistung wieder ansteigt, wird der Zustand durch den nach rechts oben weisenden Pfeil in Fig. 5 beschrieben, der an dem unteren Grenzwert SWU endet. Wenn die Eingangsleistung Pin wieder so weit angestiegen ist, dass die Ausgangsleistung den unteren Grenzwert SWU erreicht hat, wird die Verringerung der zusätzlichen Signalverstärkung wieder rückgängig gemacht und es findet ein Versatz in vertikaler Richtung entlang dem nach oben weisenden Pfeil statt, der an dem unteren Grenzwert SWU beginnt.

Eine konkrete Realisierung einer Hysterese um den unteren Grenzwert, die entsprechender Weise auch um den oberen Grenzwert SWO herum ausgeführt werden könnte, wird nun anhand von Fig. 6 beschrieben. Es existiert ein zweiter unterer Grenzwert SWU2, der oberhalb des ersten unteren Grenzwertes SWU1 liegt, jedoch im Vergleich zu der Differenz zwischen oberem Grenzwert SWO und erstem unteren Grenzwert SWU1 nahe bei dem ersten unteren Grenzwert SWU1 liegt. "Nahe" bedeutet nicht nur in Bezug auf das Ausführungsbeispiel von Fig. 6 insbesondere, dass die beiden unteren Grenzwerte SWU oder im entsprechenden Fall die beiden oberen Grenzwerte SWO um eine Pegeldifferenz voneinander entfernt liegen, die kleiner ist als 1/10 der Pegeldifferenz zwischen dem oberen Grenzwert oder dem ersten oberen Grenzwert und dem unteren Grenzwert oder dem ersten unteren Grenzwert, vorzugsweise sogar kleiner als 1/20 oder besonders bevorzugt kleiner als 1/50. Alternativ oder zusätzlich bedeutet "nahe" insbesondere, dass die beiden oberen Grenzwerte und/oder die beiden unteren Grenzwerte um höchstens 4 dB, vorzugsweise um höchstens 3 dB und besonders bevorzugt um höchstens 2 dB auseinander liegen.

Durch die zwei unteren Grenzwerte SWU1 und SWU2 ist die bereits anhand von Fig. 5 beschriebene Hysterese leicht modifiziert. Wenn sich die Eingangsleistung Pin reduziert, entsprechend dem Verhalten gemäß dem von rechts oben nach links unten weisenden Pfeil und der erste untere Grenzwert SWU1 erreicht ist, wird die resultierende Signalverstärkung reduziert, wie der vertikal nach unten weisende Pfeil darstellt. Wenn sich die Eingangsleistung Pin wieder vergrößert und den Bereich der unteren Grenzwerte SWU1, SWU2 erreicht, wird aber die resultierende Signalverstärkung erst dann wieder vergrößert, wenn der zweite, höher gelegene untere Grenzwert SWU2 erreicht ist. Dadurch kann vermieden werden, dass bereits bei Erreichen des niedriger gelegenen, ersten unteren Grenzwertes SWU1 aufgrund von ansteigender Eingangsleistung Pin wieder die resultierende Signalverstärkung stufenartig erhöht wird, die Eingangsleistung Pin unmittelbar danach aber wieder deutlich abfällt und daher die Erhöhung der resultierenden Signalverstärkung noch nicht nötig gewesen wäre.

Das Konzept der zwei verschiedenen Grenzwerte, das in dem Beispiel von Fig. 6 erläutert wurde, ist insbesondere dann von besonderem Vorteil, wenn die Erhöhung oder Erniedrigung der resultierenden Signalverstärkung als Anpassung um einen geringeren Betrag als in Fig. 6 dargestellt ausgeführt wird. Liegt der Betrag der Veränderung der resultierenden Signalverstärkung näher bei dem Betrag der Differenz zwischen dem zweiten und dem ersten Grenzwert (z.B. SWU2 - SWU1), dann führt das Konzept der zwei Grenzwerte zu einem deutlich stabileren Verhalten als wenn lediglich ein unterer oder oberer Grenzwert vorhanden wäre.

Aus den Fig. 4 bis 6 geht hervor, dass in allen Zuständen, die durch Kennlinien repräsentiert werden, welche sich unterhalb des unteren Grenzwertes SWU bis zum Minimalwert Pmin der Eingangsleistung Pin erstrecken, eine Erhöhung der resultierenden Signalverstärkung stattfindet, wenn die Eingangsleistung Pin sich erhöht und daher der untere Grenzwert SWU von unten erreicht wird. Dabei ist diese Erhöhung so groß, dass eine Kennlinie erreicht wird, auf der der Maximalwert Pmax der Eingangsleistung Pin nicht unterhalb des oberen Grenzwerts SWO erreicht wird. Dies hat den Vorteil, dass keine weiteren Anpassungen der resultierenden Signalverstärkung bei weiter ansteigender Eingangsleistung Pin erforderlich ist, bis der obere Grenzwert SWO erreicht ist.

Wie auch in den Fig. 4 bis Fig. 6 ist in dem Diagramm der Fig. 7 die Eingangsleistung Pin in Richtung der Abszisse aufgetragen, während die Ausgangsleistung Pout und der Signalpegel Pdet in Ordinatenrichtung aufgetragen sind. Die links in der Figur diagonal von links unten nach rechts oben verlaufende Linie mit einem Doppelpfeil stellt eine der Linien dar, die bereits in Fig. 4 bis Fig. 6 dargestellt sind und die im zulässigen Bereich der Werte für die Eingangsleistung Pin, der Ausgangsleistung Pout und des Signalpegels Pdet liegen. Steigt der Signalpegel Pdet z.B. während des Betriebs des Mobilfunkgeräts an (z.B. weil sich das Mobilfunkgerät von der Basisstation entfernt und daher mit höherer Sendeleistung sendet), erreicht der Signalpegel Pdet den ersten oberen Grenzwert SWO1. Mit weiter zunehmender Eingangsleistung Pin wird die resultierende Signalverstärkung um eine Stufe DP (z. B. um 1 dB) reduziert. Steigt die Eingangsleistung Pin weiter an, wird die Vorgehensweise wiederholt: Immer dann, wenn der Signalpegel Pdet wieder den ersten oberen Grenzwert SWO1 erreicht, wird der Signalpegel Pdet und somit auch die Ausgangsleistung Pout um die Stufe DP reduziert.

Fällt z.B. nach fünf solchen stufenweisen Reduzierungen der resultierenden Signalverstärkung die Eingangsleistung Pin wieder, wird auch die Ausgangsleistung Pout reduziert wie es die rechts in Fig. 7 dargestellte, von rechts oben nach links unten verlaufende Linie mit einem Pfeil zeigt. Es wird der zweite obere Grenzwert SWO2 erreicht. Dies löst eine Vergrößerung der resultierenden Signalverstärkung aus, wobei der Signalpegel Pdet wieder um die Stufe DP (z. B. um 1 dB) erhöht wird. Bei weiterem Absinken des Signalpegels Pdet wird diese stufenweise Erhöhung der resultierenden Signalverstärkung jeweils mit Erreichen des zweiten unteren Grenzwertes SWO2 wiederholt. Schließlich wird wieder die links in Fig. 7 dargestellte von rechts oben nach links unten verlaufende Kennlinie erreicht. Nun kann die stufenweise Erhöhung der resultierenden Signalverstärkung beendet werden und die Anordnung befindet sich wieder in dem Zustand vor dem Erreichen des ersten oberen Grenzwertes SWO1.

Diese Vorgehensweise ist von Vorteil, da auf diese Weise verhindert werden kann, dass sich durch die Erhöhung der zusätzlichen Dämpfung (insbesondere aufgrund einer Erhöhung der Kopplungsdämpfung der oben genannten Kopplungseinrichtung bei einem Verrutschen des Mobilfunkgeräts) eine Situation ergibt, in der die zusätzliche Dämpfung hoch ist und das Mobilfunkgerät versucht, die Sendeleistung zu erhöhen (etwa weil sich das Mobilfunkgerät wieder von seiner Basisstation entfernt). Wenn in einer solchen Situation die resultierende Signalverstärkung noch niedrig ist, kann der erste obere Grenzwertes SWO1 unter Umständen nicht erreicht werden, d.h. die maximal mögliche Ausgangsleistung wird nicht erreicht. Im Kennlinienfeld der Fig. 4 wird dieser Zustand durch die gestrichelte Kennlinie rechts in Fig. 4 dargestellt.

Allgemein wird es daher bevorzugt, dass nach einem Erreichen des ersten oberen Grenzwertes SWO1 aufgrund eines steigenden Signalpegels Pdet und Reduzierung der resultierenden Signalverstärkung (insbesondere durch Erhöhung der Dämpfung) sowie anschließendem Absinken des Signalpegels Pdet bis zum zweiten oberen Grenzwert SWO2 die resultierende Signalverstärkung wieder (insbesondere stufenweise) so weit erhöht wird, dass sie wieder den Wert hat, den sie vor dem Erreichen des ersten oberen Grenzwertes SWoi hatte, bevor der Signalpegel Pdet wieder unter den zweiten oberen Grenzwert SWo2 fällt. Optional kann die resultierende Signalverstärkung sogar noch weiter erhöht werden, bevor dass der Signalpegel Pdet wieder unter den zweiten oberen Grenzwert SWo2.

## Patentansprüche

1. Schaltungsanordnung zum Kompensieren einer Signal-Dämpfung bei der Übertragung von Sendesignalen eines Mobilfunkgeräts (1), wobei die Schaltungsanordnung für den Betrieb mit Mobilfunkgeräten konfiguriert ist, deren Sendeleistung durch einen jeweiligen Mobilfunkstandard durch einen Minimalwert, Pmin, und einen Maximalwert, Pmax, begrenzt ist, wobei die Schaltungsanordnung aufweist:
- eine einstellbare Signalpegel-Verstärkungseinrichtung, die zumindest einen Signalverstärker (7) zum Verstärken der Sendesignale mit einer von dem Signalverstärker (7) erzeugten Signal-Verstärkung aufweist,
- eine Einstelleinrichtung (11) zur Einstellung einer von der Signalpegel-Verstärkungseinrichtung erzeugten resultierenden Signalverstärkung,
- eine Detektoranordnung (9), die ausgestaltet ist zu detektieren, ob ein detektierter Signalpegel der an der Detektoranordnung detektierten Sendesignale eines Mobilfunkgeräts (1) einen vorgegebenen oberen Grenzwert, SWO, erreicht oder überschreitet und ob der detektierte Signalpegel einen vorgegebenen unteren Grenzwert, SWU, erreicht oder unterschreitet, wobei
a) die Detektoranordnung (9) und die Einstelleinrichtung (11) miteinander verbunden sind,
b) die Detektoranordnung (9) ausgestaltet ist, bei Erreichen oder Überschreiten des oberen Grenzwertes, SWO, die Einstelleinrichtung (11) zu veranlassen, die von der Signalpegel-Verstärkungseinrichtung erzeugte resultierende Signalverstärkung zu verkleinern,
c) die Detektoranordnung (9) ausgestaltet ist, bei Erreichen oder Unterschreiten des unteren Grenzwertes, SWU, von oben die Einstelleinrichtung (11) zu veranlassen, die von der Signalpegel-Verstärkungseinrichtung erzeugte resultierende Signalverstärkung zu verkleinern, und
d) die Detektoranordnung (9) ferner ausgestaltet ist, bei Erreichen des unteren Grenzwertes, SWU, von unten, die Einstelleinrichtung (11) zu veranlassen, die von der Signalpegel-Verstärkungseinrichtung erzeugte resultierende Signalverstärkung derart zu erhöhen, dass die von der Signalpegel-Verstärkungseinrichtung erzeugte resultierende Signalverstärkung eine Kennlinie hat, die so verläuft, dass für ein mit der Sendeleistung Pmax sendendes Mobilfunkgerät (1) der detektierte Signalpegel nicht unterhalb des oberen Grenzwertes, SWO, erreicht wird.

2. Schaltungsanordnung nach Anspruch 1, wobei die Schaltungseinrichtung weiterhin aufweist:
- eine Dämpfungseinrichtung (5), die derart mit dem Signalverstärker (7) kombiniert ist, dass die Sendesignale entsprechend der resultierenden Verstärkung, die aus der erzeugten Signal-Verstärkung des Signalverstärkers (7) und aus einer von der Dämpfungseinrichtung (5) erzeugten Signal-Dämpfung resultiert, verstärkt werden, wobei die von der Dämpfungseinrichtung (5) erzeugte Signal-Dämpfung von der Einstelleinrichtung (11) einstellbar ist.

3. Schaltungsanordnung nach Anspruch 2, wobei die Signal-Verstärkung des Signalverstärkers (7) konstant ist.

4. Schaltungsanordnung nach Anspruch 2 oder 3, wobei die Dämpfungseinrichtung (5) eine digitale Dämpfungseinrichtung (5) ist, deren Signal-Dämpfung stufenweise durch die Einstelleinrichtung (11) vergrößert und verkleinert werden kann.

5. Schaltungsanordnung nach einem der Ansprüche 1 bis **4,** wobei der obere Grenzwert, SWO, ein erster oberer Grenzwert ist und die Schaltungsanordnung ausgestaltet ist, die von der Signalpegel-Verstärkungseinrichtung erzeugte resultierende Verstärkung zu vergrößern, wenn die Detektoranordnung (9) detektiert, dass der Signalpegel der Sendesignale eines Mobilfunkgeräts (1) einen zweiten vorgegebenen oberen Grenzwert, der unterhalb des ersten oberen Grenzwertes, SWO, liegt, aber oberhalb des unteren Grenzwertes, SWU, liegt, erreicht oder unterschreitet.

6. Schaltungsanordnung nach einem der Ansprüche 1 bis 5, wobei der untere Grenzwert, SWU, ein erster unterer Grenzwert, SWU1, ist und die Schaltungsanordnung ausgestaltet ist, die von der Signalpegel-Verstärkungseinrichtung erzeugte resultierende Verstärkung zu vergrößern, wenn die Detektoranordnung (9) detektiert, dass der Signalpegel der Sendesignale eines Mobilfunkgeräts (1) einen zweiten vorgegebenen unteren Grenzwert, SWU2, der oberhalb des ersten unteren Grenzwertes, SWU1, liegt, aber unterhalb des oberen Grenzwertes, SWO, liegt, erreicht oder überschreitet.

7. Verfahren zum Kompensieren einer Signal-Dämpfung bei der Übertragung von Sendesignalen eines Mobilfunkgeräts (1), wobei die Sendeleistung eines Mobilfunkgeräts (1) durch einen jeweiligen Mobilfunkstandard durch einen Minimalwert, Pmin, und einen Maximalwert, Pmax, begrenzt ist, das Verfahren umfassend:
- Verstärken der Sendesignale mit einer von einem Signalverstärker (7) erzeugten Signal-Verstärkung,
- Einstellen einer von einer einstellbaren Signalpegel-Verstärkungseinrichtung, die zumindest den Signalverstärker (7) aufweist, erzeugten resultierenden Signalverstärkung, abhängig von einem Signalpegel der Sendesignale eines Mobilfunkgeräts,
- Detektieren, ob ein detektierter Signalpegel einen vorgegebenen oberen Grenzwert, SWO, erreicht oder überschreitet und ob der detektierte Signalpegel einen vorgegebenen unteren Grenzwert, SWU, erreicht oder unterschreitet, wobei
a) bei Erreichen oder Überschreiten des oberen Grenzwertes, SWO, die von der Signalpegel-Verstärkungseinrichtung erzeugte resultierende Signalverstärkung verkleinert wird,
b) bei Erreichen oder Unterschreiten des unteren Grenzwertes, SWU, von oben die von der Signalpegel-Verstärkungseinrichtung erzeugte resultierende Signalverstärkung verkleinert wird, und
c) bei Erreichen des unteren Grenzwertes, SWU, von unten, die von der Signalpegel-Verstärkungseinrichtung erzeugte resultierende Signalverstärkung derart erhöht wird, dass die von der Signalpegel-Verstärkungseinrichtung erzeugte resultierende Signalverstärkung eine Kennlinie hat, die so verläuft, dass für ein mit der Sendeleistung Pmax sendendes Mobilfunkgerät (1) der detektierte Signalpegel nicht unterhalb des oberen Grenzwertes, SWO, erreicht wird.

8. Verfahren nach Anspruch 7, weiterhin umfassend:
- Dämpfen der Sendesignale von einer Dämpfungseinrichtung (5), sodass die Sendesignale entsprechend der resultierenden Verstärkung, die aus der erzeugten Signalverstärkung des Signalverstärkers (7) und aus einer von der Dämpfungseinrichtung (5) erzeugten Signal-Dämpfung resultiert, verstärkt werden,
- wobei das Einstellen der von der einstellbaren Signalpegel-Verstärkungseinrichtung erzeugten resultierenden Signalverstärkung ein Einstellen der von der Dämpfungseinrichtung (5) erzeugten Signal-Dämpfung, abhängig von dem Signalpegel der Sendesignale eines Mobilfunkgeräts (1), umfasst.

9. Verfahren nach Anspruch 8, wobei die Signal-Verstärkung des Verstärkers konstant gehalten wird.

10. Verfahren nach Anspruch 8 oder 9, wobei die Dämpfungseinrichtung (5) vorgegebene, diskrete Werte der Signal-Dämpfung hat und die Signal-Dämpfung entsprechend von Differenzen der diskreten Werte stufenweise vergrößert und verkleinert wird.

11. Verfahren nach einem der Ansprüche 7 bis 10, wobei der obere Grenzwert ein erster oberer Grenzwert ist und die von der Signalpegel-Verstärkungseinrichtung erzeugte resultierende Signalverstärkung vergrößert wird, wenn das Detektieren ergibt, dass der Signalpegel der Sendesignale eines Mobilfunkgeräts (1) einen zweiten vorgegebenen oberen Grenzwert, SWO, der unterhalb des ersten oberen Grenzwertes, SWO, liegt, aber oberhalb des unteren Grenzwertes, SWU, liegt, erreicht oder unterschreitet.

12. Verfahren nach einem der Ansprüche 7 bis 11, wobei der untere Grenzwert ein erster unterer Grenzwert ist und die von der Signalpegel-Verstärkungseinrichtung erzeugte resultierende Signalverstärkung vergrößert wird, wenn das Detektieren ergibt, dass der Signalpegel der Sendesignale des Mobilfunkgeräts (1) einen zweiten vorgegebenen unteren Grenzwert, SWU2, der oberhalb des ersten unteren Grenzwertes, SWU1, liegt, aber unterhalb des oberen Grenzwertes, SWO, liegt, erreicht oder überschreitet.

## Claims

1. Circuit arrangement for compensating signal damping while transmitting transmission signals of a mobile radio device (1), the circuit arrangement being configured for operation with mobile radio devices, the transmission power of which is delimited by a respective mobile radio standard by a minimum value, Pmin, and a maximum value, Pmax, wherein the circuit arrangement comprises:
- a settable signal level amplification device, which has at least one signal amplifier (7) for amplifying the transmission signals with a signal amplification generated by the signal amplifier (7),
- a setting device (11) for setting a resulting signal amplification generated by the signal level amplification device,
- a detector arrangement (9) configured to detect whether a detected signal level of the transmission signals of a mobile radio device (1) detected at the detector arrangement reaches or exceeds a predefined upper limit value, SWO, and whether the detected signal level reaches or falls below a predefined lower limit value, SWU,
a) the detector arrangement (9) and the setting device (11) are connected to one another,
b) the detector arrangement (9) is configured, if the upper limit value, SWO, is reached or exceeded, to cause the setting device (11) to reduce the resulting signal amplification generated by the signal level amplification device,
c) the detector arrangement (9) is configured, if the lower limit value, SWU, is reached or fallen below, from above, to cause the setting device (11) to reduce the resulting signal amplification generated by the signal level amplification device, and
d) the detector arrangement (9) is further configured, if the lower limit value, SWU, is reached, from below, to cause the setting device (11) to increase the resulting signal amplification generated by the signal level amplification device such that the resulting signal amplification generated by the signal level amplification device has a characteristic curve which extends such that for a mobile radio device (1) transmitting at the transmission power Pmax the detected signal level is reached not below the upper limit value, SWO.

2. Circuit arrangement according to claim 1, wherein the circuit device further comprises:
- a damping device (5), which is combined with the signal amplifier (7) such that the transmission signals are amplified according to the resulting amplification, which results from the generated signal amplification of the signal amplifier (7) and from a signal damping generated by the damping device (5), wherein the signal damping generated by the damping device (5) can be set by the setting device (11).

3. Circuit arrangement according to claim 2, wherein the signal amplification of the signal amplifier (7) is constant.

4. Circuit arrangement according to claim 2 or claim 3, wherein the damping device (5) is a digital damping device (5), the signal damping of which can be increased and reduced in a stepwise manner by the setting device (11).

5. Circuit arrangement according to any one of claims 1 to 4, wherein the upper limit value, SWO, is a first upper limit value and the circuit arrangement is configured to increase the resulting amplification generated by the signal level amplification device, if the detector arrangement (9) detects that the signal level of the transmission signals of a mobile radio device (1) reaches or falls below a second predefined upper limit value, which is below the first upper limit value, SWO, but above the lower limit value, SWU.

6. Circuit arrangement according to any one of claims 1 to 5, wherein the lower limit value, SWU, is a first lower limit value, SWU1, and the circuit arrangement is configured to increase the resulting signal amplification generated by the signal level amplification device, if the detector arrangement (9) detects that the signal level of the transmission signals of a mobile radio device (1) reaches or exceeds a second predefined lower limit value, SWU2, which is above the first lower limit value, SWU1, but below the upper limit value, SWO.

7. Method for compensating signal damping while transmitting transmission signals of a mobile radio device (1), wherein the transmission power of a mobile radio device (1) is delimited by a respective mobile radio standard by a minimum value, Pmin, and a maximum value, Pmax, the method comprising:
- amplifying the transmission signals with a signal amplification generated by a signal amplifier (7),
- setting a resulting signal amplification generated by a settable signal level amplification device, which comprises at least the signal amplifier (7), depending on a signal level of the transmission signals of a mobile radio device,
- detecting whether a detected signal level reaches or exceeds a predefined upper limit value, SWO, and whether the detected signal level reaches or falls below a predefined lower limit value, SWU, wherein
a) if the upper limit value, SWO, is reached or exceeded, the resulting signal amplification generated by the signal level amplification device is reduced,
b) if the lower limit value, SWU, is reached or fallen below, from above, the resulting signal amplification generated by the signal level amplification device is reduced, and
c) if the lower limit value, SWU, is reached, from below, the resulting signal amplification generated by the signal level amplification device is increased such that the resulting signal amplification generated by the signal level amplification device has a characteristic curve which extends such that for a mobile radio device (1) transmitting at transmission power Pmax the detected signal level is reached not below the upper limit value, SWO.

8. Method according to claim 7, further comprising:
- damping the transmission signals from a damping device (5), so that the transmission signals are amplified according to the resulting amplification, which results from the generated signal amplification of the signal amplifier (7) and from a signal damping generated by the damping device (5),
- wherein the setting of the resulting signal amplification generated by the settable signal level amplification device comprises setting the signal damping generated by the damping device (5), depending on the signal level of the transmission signals of a mobile radio device (1).

9. Method according to claim 8, wherein the signal amplification of the amplifier is kept constant.

10. Method according to claim 8 or 9, wherein the damping device (5) has predefined, discrete values of the signal damping and the signal damping is increased and reduced in a stepwise manner according to differences of discrete values.

11. Method according to any one of claims 7 to 10, wherein the upper limit value is a first upper limit value and the resulting signal amplification generated by the signal level amplification device is increased if the detection reveals that the signal level of the transmission signals of a mobile radio device (1) reaches or falls below a second predefined upper limit value, SWO, which is below the first upper limit value, SWO, but above the lower limit value, SWU.

12. Method according to any one of claims 7 to 11, wherein the lower limit value is a first lower limit value and the resulting signal amplification generated by the signal level amplification device is increased if the detection reveals that the signal level of the transmission signals of the mobile radio device (1) reaches or exceeds a second predefined lower limit value, SWU2, which is above the first lower limit value, SWU1, but below the upper limit value, SWO.

## Revendications

1. Ensemble de circuit pour compenser une atténuation de signal lors de la transmission de signaux d'émission d'un appareil de téléphonie mobile (1), dans lequel l'ensemble de circuit est configuré pour fonctionner avec des appareils de téléphonie mobile dont la puissance d'émission est limitée par une norme de téléphonie mobile respective entre une valeur minimale, Pmin, et une valeur maximale, Pmax, dans lequel l'ensemble de circuit comporte :
- un dispositif réglable d'amplification de niveau de signal, qui comporte au moins un amplificateur de signal (7) pour amplifier les signaux d'émission avec une amplification de signal générée par l'amplificateur de signal (7),
- un dispositif de réglage (11) pour régler une amplification de signal résultante générée par le dispositif d'amplification de niveau de signal,
- un ensemble détecteur (9) qui est conçu pour détecter si un niveau de signal détecté des signaux d'émission d'un appareil de téléphonie mobile (1) détectés sur l'ensemble détecteur atteint ou dépasse une valeur limite supérieure, SWO, prédéfinie, et si le niveau de signal détecté atteint ou passe au-dessous d'une valeur limite inférieure, SWU, prédéfinie, dans lequel
a) l'ensemble détecteur (9) et le dispositif de réglage (11) sont reliés entre eux,
b) l'ensemble détecteur (9) est conçu pour, en cas d'atteinte ou de dépassement de la valeur limite supérieure, SWO, amener le dispositif de réglage (11) à réduire l'amplification de signal résultante générée par le dispositif d'amplification de niveau de signal,
c) l'ensemble détecteur (9) est conçu pour, en cas d'atteinte ou de passage au-dessous de la valeur limite inférieure, SWU, par le haut, amener le dispositif de réglage (11) à réduire l'amplification de signal résultante générée par le dispositif d'amplification de niveau de signal, et
d) l'ensemble détecteur (9) est en outre conçu pour, en cas d'atteinte de la valeur limite inférieure, SWU, par le bas, amener le dispositif de réglage (11) à accroître l'amplification de signal résultante générée par le dispositif d'amplification de niveau de signal de telle sorte que l'amplification de signal résultante générée par le dispositif d'amplification de niveau de signal présente une courbe caractéristique qui s'étende de telle sorte que, pour un appareil de téléphonie mobile (1) émettant avec la puissance d'émission Pmax, le niveau de signal détecté ne soit pas inférieur à la valeur limite supérieure, SWO.

2. Ensemble de circuit selon la revendication 1, dans lequel le dispositif de circuit comporte en outre :
- un dispositif d'atténuation (5), qui est combiné avec l'amplificateur de signal (7) de telle sorte que les signaux d'émission soient amplifiés en fonction de l'amplification résultante qui résulte de l'amplification de signal générée de l'amplificateur de signal (7), et d'une atténuation de signal générée par le dispositif d'atténuation (5), dans lequel l'atténuation de signal générée par le dispositif d'atténuation (5) peut être réglée par le dispositif de réglage (11).

3. Ensemble de circuit selon la revendication 2, dans lequel l'amplification de signal de l'amplificateur de signal (7) est constante.

4. Ensemble de circuit selon la revendication 2 ou 3, dans lequel le dispositif d'atténuation (5) est un dispositif d'atténuation (5) numérique dont l'atténuation de signal peut être augmentée et diminuée progressivement par le dispositif de réglage (11).

5. Ensemble de circuit selon l'une des revendications 1 à 4, dans lequel la valeur limite supérieure, SWO, est une première valeur limite supérieure, et l'ensemble de circuit est conçu pour augmenter l'amplification résultante générée par le dispositif d'amplification de niveau de signal lorsque l'ensemble détecteur (9) détecte que le niveau de signal des signaux d'émission d'un appareil de téléphonie mobile (1) atteint ou passe au-dessous d'une deuxième valeur limite supérieure prédéfinie qui est inférieure à la première valeur limite supérieure, SWO, mais qui est supérieure à la valeur limite inférieure, SWU.

6. Ensemble de circuit selon l'une des revendications 1 à 5, dans lequel la valeur limite inférieure, SWU, est une première valeur limite inférieure, SWU₁, et l'ensemble de circuit est conçu pour augmenter l'amplification résultante générée par le dispositif d'amplification de niveau de signal lorsque l'ensemble détecteur (9) détecte que le niveau de signal des signaux d'émission d'un appareil de téléphonie mobile (1) atteint ou dépasse une deuxième valeur limite inférieure, SWU₂, prédéfinie qui est supérieure à la première valeur limite inférieure, SWU₁, mais qui est inférieure à la valeur limite supérieure, SWO.

7. Procédé pour compenser une atténuation de signal lors de la transmission de signaux d'émission d'un appareil de téléphonie mobile (1), dans lequel la puissance d'émission d'un appareil de téléphonie mobile (1) est limitée par une norme de téléphonie mobile respective entre une valeur minimale, Pmin, et une valeur maximale, Pmax, le procédé comprenant :
- l'amplification des signaux d'émission avec une amplification de signal générée par un amplificateur de signal (7),
- le réglage d'une amplification de signal résultante générée par un dispositif réglable d'amplification de niveau de signal, qui inclut au moins l'amplificateur de signal (7), en fonction d'un niveau de signal des signaux d'émission d'un appareil de téléphonie mobile,
- la détection si un niveau de signal détecté atteint ou dépasse une valeur limite supérieure, SWO, prédéfinie et si le niveau de signal détecté atteint ou passe au-dessous d'une valeur limite inférieure, SWU, prédéfinie, dans lequel
a) en cas d'atteinte ou de dépassement de la valeur limite supérieure, SWO, l'amplification de signal résultante générée par le dispositif d'amplification de niveau de signal est réduite,
b) en cas d'atteinte ou de passage au-dessous de la valeur limite inférieure, SWU, par le haut, l'amplification de signal résultante générée par le dispositif d'amplification de niveau de signal est réduite, et
c) en cas d'atteinte de la valeur limite inférieure, SWU, par le bas, l'amplification de signal résultante générée par le dispositif d'amplification de niveau de signal est accrue de telle sorte que l'amplification de signal résultante générée par le dispositif d'amplification de niveau de signal présente une courbe caractéristique qui s'étende de sorte que, pour un appareil de téléphonie mobile (1) émettant avec la puissance d'émission Pmax, le niveau de signal détecté ne soit pas inférieur à la valeur limite supérieure, SWO.

8. Procédé selon la revendication 7, comprenant en outre :
- l'atténuation des signaux d'émission par un dispositif d'atténuation (5) de sorte que les signaux d'émission soient amplifiés en fonction de l'amplification résultante qui résulte de l'amplification de signal générée de l'amplificateur de signal (7), et d'une atténuation de signal générée par le dispositif d'atténuation (5),
- dans lequel le réglage de l'amplification de signal résultante générée par le dispositif réglable d'amplification de niveau de signal comprend un réglage de l'atténuation de signal, générée par le dispositif d'atténuation (5), en fonction du niveau de signal des signaux d'émission d'un appareil de téléphonie mobile (1).

9. Procédé selon la revendication 8, dans lequel l'amplification de signal de l'amplificateur est maintenue constante.

10. Procédé selon la revendication 8 ou 9, dans lequel le dispositif d'atténuation (5) possède des valeurs discrètes prédéfinies d'atténuation de signal, et l'atténuation de signal est augmentée et réduite progressivement en fonction des différences des valeurs discrètes.

11. Procédé selon l'une des revendications 7 à 10, dans lequel la valeur limite supérieure est une première valeur limite supérieure, et l'amplification de signal résultante générée par le dispositif d'amplification de niveau de signal est augmentée lorsque la détection aboutit à ce que le niveau de signal des signaux d'émission d'un appareil de téléphonie mobile (1) atteigne ou passe au-dessous d'une deuxième valeur limite supérieure, SWO, prédéfinie, qui est inférieure à la première valeur limite supérieure, SWO, mais est supérieure à la valeur limite inférieure, SWU.

12. Procédé selon l'une des revendications 7 à 11, dans lequel la valeur limite inférieure est une première valeur limite inférieure, et l'amplification de signal résultante générée par le dispositif d'amplification de niveau de signal est augmentée lorsque la détection aboutit à ce que le niveau de signal des signaux d'émission de l'appareil de téléphonie mobile (1) atteigne ou dépasse une deuxième valeur limite inférieure, SWU₂, prédéfinie, qui est supérieure à la première valeur limite inférieure, SWU₁, mais est inférieure à la valeur limite supérieure, SWO.
